(19) Europäisches Patentamt / European Patent Office / Office européen des brevets

(11) **EP 4 648 585 A1**

(12) **EUROPEAN PATENT APPLICATION**
published in accordance with Art. 153(4) EPC

(43) Date of publication:
**12.11.2025 Bulletin 2025/46**

(21) Application number: **24749932.0**

(22) Date of filing: **16.01.2024**

(51) International Patent Classification (IPC):
*H10K 50/852* (2023.01)   *H10K 50/19* (2023.01)
*H10K 50/854* (2023.01)   *H10K 50/858* (2023.01)
*H10K 59/10* (2023.01)   *H10K 59/35* (2023.01)
*H10K 59/38* (2023.01)   *H10K 59/60* (2023.01)

(52) Cooperative Patent Classification (CPC):
**H10K 50/19; H10K 50/852; H10K 50/854;
H10K 50/858; H10K 59/10; H10K 59/35;
H10K 59/38; H10K 59/60**

(86) International application number:
**PCT/JP2024/000941**

(87) International publication number:
**WO 2024/161978 (08.08.2024 Gazette 2024/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.01.2023   JP 2023013285
06.11.2023   JP 2023189525**

(71) Applicant: **Canon Kabushiki Kaisha
Tokyo, 146-8501 (JP)**

(72) Inventors:
• **GOMMORI, Eisuke**
  **Tokyo 146-8501 (JP)**
• **HINATA, Shoma**
  **Tokyo 146-8501 (JP)**
• **ISHIZUYA, Koji**
  **Tokyo 146-8501 (JP)**
• **KAJIMOTO, Norifumi**
  **Tokyo 146-8501 (JP)**

(74) Representative: **WESER & Kollegen
Patentanwälte PartmbB
Radeckestraße 43
81245 München (DE)**

(54) **LIGHT EMITTING DEVICE, PHOTOELECTRIC CONVERSION DEVICE, ELECTRONIC APPARATUS, ILLUMINATION DEVICE, AND MOBILE BODY**

(57)    A light emitting device comprises a first light emitting element and a second light emitting element formed on a substrate, and a first microlens and a second microlens. The first light emitting element includes a first light emitting layer, and an optical resonance structure having a first optical path length, and the second light emitting element includes a second light emitting layer, and an optical resonance structure having a second optical path length longer than the first optical path length. Assuming that an area of a region where light having entered from a normal direction of the substrate and having passed through the first microlens enters a light emission region of the first light emitting layer is defined as S1, an area of the light emission region of the first light emitting layer is defined as S1', an area of a region where light having entered from a normal direction of the substrate and having passed through the second microlens enters a light emission region of the second light emitting layer is defined as S2, and an area of the light emission region of the second light emitting layer is defined as S2', then $|S_1 - S_1'| < |S_2 - S_2'|$.

F I G. 5A

**Description**

TECHNICAL FIELD

The present invention relates to a light emitting device, a photoelectric conversion device, an electronic apparatus, an illumination device, and a moving body.

BACKGROUND ART

An organic light emitting element called an organic electroluminescence element (organic EL element) is an electronic element including a pair of electrodes and an organic compound layer arranged between the electrodes. Excitons of a luminous organic compound in the organic compound layer are generated by injecting electrons and holes from the pair of electrodes to the organic compound layer, and when the excitons return to a ground state, the organic light emitting element emits light. Light emitting devices using organic light emitting elements have been put to practical use. In PTL 1, for the purpose of improving the light extraction efficiency or the view angle characteristic, the relationship between the half-width of the spectrum of a light emitting element and the curvature of a microlens is specified.

CITATION LIST

PATENT LITERATURE

PTL 1: Japanese Patent Laid-Open No. 2022-80507

SUMMARY OF INVENTION

TECHNICAL PROBLEM

In a light emitting element having an optical resonance structure, the light radiation distribution has more components in the front direction. In a light emitting device including light emitting elements having different interference orders of resonators, a difference in view angle characteristic can occur. The present invention can provide a technique advantageous in improving the view angle characteristic in a light emitting device including light emitting elements each having a resonance structure. In other words, the present invention provides a technique capable of suppressing a difference in view angle characteristic between pixels having different interference orders.

SOLUTION TO PROBLEM

A light emitting device according to the present invention is a light emitting device that comprises a first light emitting element and a second light emitting element formed on a substrate, and a first microlens and a second microlens arranged so as to correspond to the first light emitting element and the second light emitting element, respectively, the first light emitting element including a first light emitting layer containing an organic compound, and an optical resonance structure having a first optical path length, and the second light emitting element including a second light emitting layer containing an organic compound, and an optical resonance structure having a second optical path length longer than the first optical path length, characterized in that assuming that an area of a region where light having entered from a normal direction of the substrate and having passed through the first microlens enters a light emission region of the first light emitting layer and a periphery thereof is defined as S1, an area of the light emission region of the first light emitting layer is defined as S1', an area of a region where light having entered from a normal direction of the substrate and having passed through the second microlens enters a light emission region of the second light emitting layer and a periphery thereof is defined as S2, and an area of the light emission region of the second light emitting layer is defined as S2', a relationship expressed by $|S1 - S1'| < |S2 - S2'|$ is satisfied, and in each of the first light emitting element and the second light emitting element, one of the region where the light enters and the light emission region is included in the other region.

ADVANTAGEOUS EFFECTS OF INVENTION

According to the present invention, it is possible to provide a technique advantageous in improving the view angle characteristic in a light emitting device including light emitting elements each having a resonance structure. In other words, it is possible to suppress a difference in view angle characteristic between pixels having different interference orders.
Other features and advantages of the present invention will be apparent from the following description taken in conjunction with the accompanying drawings. Note that the same reference numerals denote the same or like components throughout the accompanying drawings.

## BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a sectional view showing the schematic arrangement of a light emitting device;
Fig. 2 is a view showing the schematic arrangement of a light emitting element;
Fig. 3 is a view showing the schematic arrangement of the light emitting element;
Fig. 4 is a view showing the optical path of light having passed through a microlens;
Fig. 5A is a view showing an example of the optical path of light having passed through the microlens;
Fig. 5B is a view showing an example of the optical path of light having passed through the microlens;
Fig. 6A is a view showing an example of the optical path of light having passed through the microlens;
Fig. 6B is a view showing an example of the optical path of light having passed through the microlens;
Fig. 7A is a view showing an example of the optical path of light having passed through the microlens;
Fig. 7B is a view showing an example of the optical path of light having passed through the microlens;
Fig. 8 is a view for explaining an optical resonance structure;
Fig. 9 is a view showing an example of the optical path of light having passed through the microlens;
Fig. 10 is a view for explaining a microlens and a view angle;
Fig. 11 is a sectional view of the light emitting device;
Fig. 12 is a sectional view of the light emitting device;
Fig. 13 is a sectional view of the light emitting device;
Fig. 14 is a sectional view of the light emitting device;
Fig. 15 is a sectional view of the light emitting device;
Fig. 16 is a sectional view of the light emitting device;
Fig. 17 is a sectional view of the light emitting device;
Fig. 18 is a sectional view of the light emitting device;
Fig. 19 is a sectional view of the light emitting device;
Fig. 20 is a sectional view of the light emitting device;
Fig. 21 is a sectional view of the light emitting device;
Fig. 22 is a view showing an example in which color filters are arranged;
Fig. 23 is a view showing an example in which color filters are arranged;
Fig. 24 is a view showing an example in which color filters are arranged;
Fig. 25 is a view showing an example in which color filters are arranged;
Fig. 26 is a view showing an example in which color filters are arranged;
Fig. 27 is a view showing an example of a display device;
Fig. 28A is a view showing an example of an image capturing device and an electronic apparatus;
Fig. 28B is a view showing an example of an image capturing device and an electronic apparatus;
Fig. 29A is a view showing an example of a display device;
Fig. 29B is a view showing an example of a display device;
Fig. 30A is a view showing an example of an illumination device and a lighting appliance;
Fig. 30B is a view showing an example of an illumination device and a lighting appliance;
Fig. 31A is a view showing an example of a wearable device; and
Fig. 31B is a view showing an example of a wearable device.

## DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

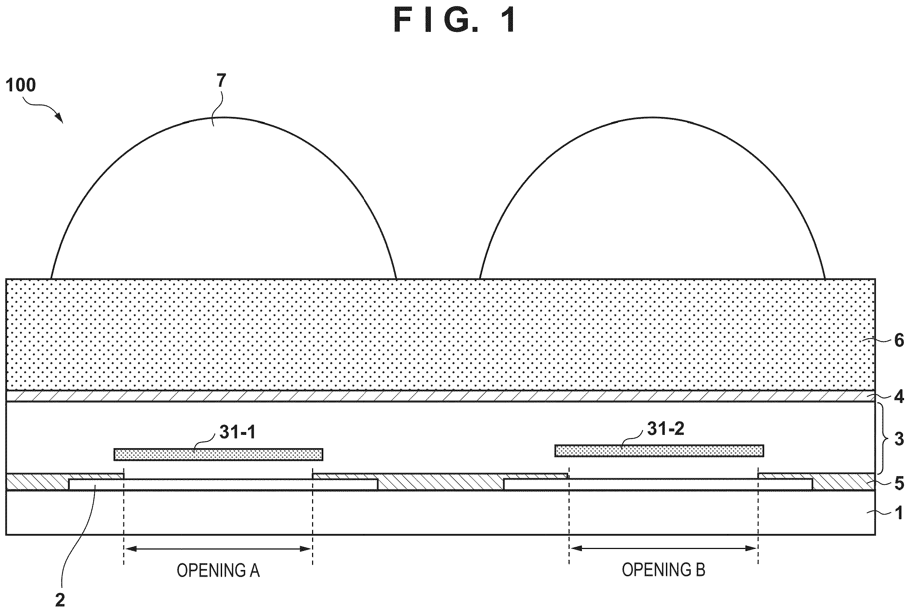

An example of a light emitting device 100 according to an embodiment will be described with reference to Fig. 1. The light emitting device 100 includes a substrate 1, lower electrodes 2, an organic compound layer 3 (a light emitting layer 31-1, a light emitting layer 31-2, and functional layers (not shown) other than the light emitting layers), an upper electrode 4, insulating layers 5, a protective layer 6, and microlenses 7. Two light emitting elements are shown in this example, but many light emitting elements may be arranged in practice. A large number of light emitting elements may be arranged in a matrix.

The lower electrode 2 is provided on the substrate 1. The upper electrode 4 is provided on the organic compound layer 3. Each of the light emitting layer 31-1 and the light emitting layer 31-2 emits light by the potential difference between the lower electrode and the upper electrode. The insulating layer 5 (bank) is provided for each of a plurality of lower electrodes 2 so as to insulate the plurality of lower electrodes from the upper electrode. Each of a plurality of insulating layers 5 includes an opening A or B (opening portion) that exposes the corresponding lower electrode 2 to the organic compound layer 3. Note that the plurality of insulating layers 5 may be considered as one insulating layer arranged in contact with the ends of the plurality of lower electrodes, and the insulating layer may be considered as including a plurality of opening portions so as to expose each of the plurality of lower electrodes 2.

The lower electrode 2 and the organic compound layer 3 are in contact with each other in the opening portion, and a portion of the organic compound layer 3 corresponding to the opening of the insulating layer 5 is a light emission region where light is emitted. The light emission region will be referred to as a light emitting portion. In Fig. 1, a plurality of light emitting portions respectively corresponding to the plurality of lower electrodes 2 are provided, and each of the openings A and B of the insulating layers 5 exposes the corresponding lower electrode 2 to the light emitting portion corresponding to the lower electrode 2. The protective layer 6 is provided on the upper electrode 4. The microlenses 7 have a plurality of curved surface portions respectively corresponding to the plurality of light emitting portions, and are provided on the protective layer 6.

The material of the substrate 1 is not particularly limited as long as the material can support the lower electrode 2, the organic compound layer 3, and the upper electrode 4. For example, glass, plastic, silicon, or the like can be used as the material of the substrate 1. A switching element such as a transistor, a wiring, an interlayer insulating film, and the like may be provided on the substrate 1.

The lower electrode 2 may be transparent or opaque. If the lower electrode 2 is a reflective layer, the material of the lower electrode 2 is preferably a metal material whose reflectance at the emission wavelength is 70% or more. For example, as the material of the lower electrode 2, a metal such as Al or Ag or an alloy obtained by adding Si, Cu, Ni, Nd, or the like to Al or Ag can be used. Alternatively, as the material of the lower electrode 2, ITO, IZO, AZO, IGZO, or the like can be used. Note that the emission wavelength means the spectrum range of light emitted from the light emitting layer 31. As long as the reflectance of the lower electrode 2 is higher than a predetermined (desired) reflectance, the lower electrode 2 may be a stacked electrode with a barrier electrode made of a metal such as Ti, W, Mo, or Au, or an alloy thereof, or a stacked electrode with a transparent oxide film electrode made of ITO, IZO, or the like.

On the other hand, if the lower electrode 2 is transparent, a reflective layer may be provided under the lower electrode 2 (on the side of the substrate 1). As the material of the transparent lower electrode 2, for example, ITO, IZO, AZO, IGZO, or the like can be used. To achieve a predetermined optical distance to be described later, a configuration in which an insulating film is provided between the reflective layer and a transparent conductive film may be adopted as the configuration of the lower electrode 2. A configuration in which the film thickness of the insulating film or the transparent conductive film is changed for each light emitting element in accordance with the color of light emitted by the light emitting element may be adopted.

The upper electrode 4 is translucent. The material of the upper electrode 4 may be a semi-transmissive material having a property of transmitting part of light that has reached the surface of the upper electrode 4 and reflecting the remaining part of the light (that is, a semi-transmissive reflective property). As the material of the upper electrode 4, for example, a transparent material such as a transparent conductive oxide can be used. As the material of the upper electrode 4, a semi-transmissive material of an elemental metal (aluminum, silver, gold, or the like), an alkali metal (lithium, cesium, or the like), an alkali earth metal (magnesium, calcium, barium, or the like), or an alloy material containing these metal materials can be used.

If a semi-transmissive material is used as the material of the upper electrode 4, an alloy containing magnesium or silver as a main component is preferably used as a semi-transmissive material. The upper electrode 4 may have a layered structure including a plurality of layers made of the above-described materials as long as the upper electrode 4 has an excellent transmittance. In Fig. 1, one upper electrode 4 common to the plurality of light emitting portions is provided, but a plurality of upper electrodes 4 respectively corresponding to the plurality of light emitting portions may be provided.

One of the lower electrode 2 and the upper electrode 4 functions as an anode, and the other functions as a cathode. For example, the lower electrode 2 functions as an anode and the upper electrode 4 functions as a cathode. The lower electrode 2 may function as a cathode and the upper electrode 4 may function as an anode.

Each of the lower electrode 2, the upper electrode 4, and the organic compound layer 3 can be formed by a known technique such as a deposition method or a spin coating method. Each of the lower electrode 2 and the upper electrode 4 may be formed from a plurality of layers. The organic compound layer includes at least one of a hole injection layer, a hole transport layer, an electron blocking layer, a light emitting layer, a hole blocking layer, an electron transport layer, and an electron injection layer.

Each of the light emitting layers 31-1 and 31-2 (to be collectively referred to as the "light emitting layers 31") emits light when holes injected from the anode and electrons injected from the cathode are recombined in the organic compound layer. Each light emitting layer 31 may include a single layer or a plurality of layers. If, for example, a light emitting layer made of a red light emitting material, a light emitting layer made of a green light emitting material, and a light emitting layer made of a blue light emitting material are combined, light beams (red light, green light, and blue light) from the respective light emitting layers can be mixed to obtain white light. Two kinds of light emitting layers whose light emission colors have a complimentary color relationship (for example, a light emitting layer made of a blue light emitting material and a light emitting layer made of a yellow light emitting material) may be combined. A material contained in a light emitting layer and the arrangement of the light emitting layer may be different for each light emitting portion so that the light emitting layer emits light of a different color for each light emitting portion. In this case, the light emitting layer may be patterned for each light emitting portion.

The light emitting device according to this embodiment may include a first reflective surface, a second reflective surface, and a light emitting layer arranged between the first reflective surface and the second reflective surface. The first reflective surface may be the lower electrode 2, a reflective layer arranged between the substrate 1 and the lower electrode 2, or a reflective layer arranged between the lower electrode 2 and the insulating layer 5. The second reflective surface may be the upper electrode 4, or a semi-transmissive reflective layer arranged between the upper electrode 4 and the microlens.

The protective layer 6 is an insulating layer, is translucent, and preferably contains an inorganic material having a low permeability for oxygen and water from the outside. For example, the protective layer 6 can be formed using an inorganic material such as silicon nitride (SiN), silicon oxynitride (SiON), silicon oxide (SiOx), aluminum oxide ($Al_2O_3$), or titanium oxide ($TiO_2$). In particular, in terms of the protection performance, an inorganic material such as SiN, SiON, or $Al_2O_3$ is preferable. A chemical vapor deposition method (CVD method), an atomic layer deposition method (ALD method), a sputtering method, or the like can preferably be used to form the protective layer 6.

The protective layer 6 can have a single-layer structure or a layered structure using the above-described materials and forming methods in combination as long as the protective layer 6 has sufficient moisture barrier property. For example, the protective layer 6 may have a layered structure of a layer of silicon nitride and another layer having a high density formed using the atomic deposition method. Furthermore, the protective layer 6 may include an organic layer as long as it has moisture barrier property. For example, the organic layer is made of polyacrylate, polyamide, polyester, epoxy, or the like. In addition, in Fig. 1, the one protective layer 6 common to the plurality of light emitting portions is provided but a plurality of protective layers 6 respectively corresponding to the plurality of light emitting portions may be provided.

The microlens 7 can be formed by an exposure process and a developing process. More specifically, a film (photoresist film) is formed using the material of the microlens 7, and the photoresist film is exposed and developed using a mask including a continuous gradation change. As the mask, a gray mask can be used. An area gradation mask that allows light irradiation with a continuous gradation change on the imaging plane by changing the density distribution of dots of a light shielding film with a resolution equal to or smaller than the resolution of an exposure device can also be used.

The lens shape can be adjusted by etching back the microlens 7 formed by the exposure process and the developing process. As described above, the microlens 7 need only have the curved surface portion that has an effect of converging light from the light emitting portion, and the curved surface portion may or may not be a part of a spherical surface. More specifically, as in this embodiment, the curved surface portion of the microlens protrudes toward the light-extraction side, and is a curved surface that is convex upward in a case where light is extracted into a layer, such as air, having a refractive index lower than that of the microlens.

In the example shown in Fig. 1, a layer contacting the microlens 7 on the light-extraction side is air. However, a refractive index $n_0$ of the layer need only be lower than a refractive index $n_1$ of the microlens, and for example, a transparent resin may be arranged on the microlens.

In this embodiment, the microlenses 7 are directly provided on the protective layer 6. However, a color filter or a light absorbing layer may be provided for the purpose of improving color purity and the view angle characteristic. A planarizing layer may be provided between the protective layer 6 and the microlenses 7 for the purpose of planarizing the unevenness of the protective layer 6. A color filter or a light absorbing layer may be provided between the protective layer 6 and the microlenses 7 or may be provided on the microlenses 7. A color filter and the protective layer 6 may be integrated, the microlenses 7 and a color filter may be integrated, or a color filter may be formed on another substrate and the substrates may be bonded so as to oppose each other. As in the example of this embodiment, the protective layer and the microlens are formed integrally, thereby forming the curved surface portion of the microlens 7 while accurately aligning it with the light emitting portion. In addition, the distance in the vertical direction between the microlens and the light emitting portion can be made small, thereby improving the view angle characteristic, as described above.

(Example of Light Emitting Element)

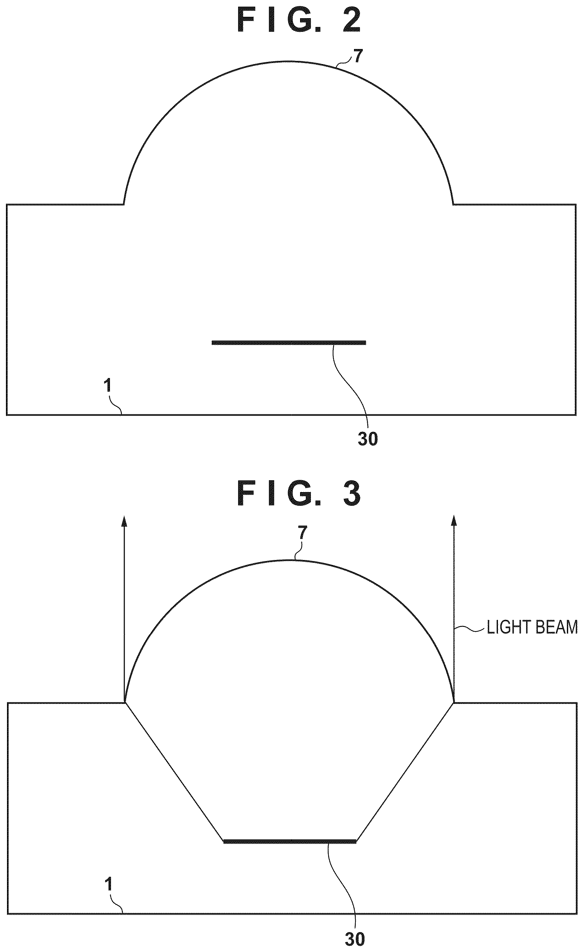

A light emitting element applied to the light emitting device according to the embodiment will be described next. Fig. 2 shows an example of the light emitting element. The light emitting element includes the substrate 1, the microlens 7, and a light emitting portion 30 provided between the substrate 1 and the microlens 7. The microlens 7 has a curved surface portion protruding toward the side opposite to the substrate, that is, the light-emission side. The light emitting portion 30 is a portion of the organic compound layer corresponding to the opening of the insulating layer 5, which is a region (light emission region) where light is emitted. Hereinafter, a direction perpendicular to the substrate is described as a "vertical direction" and a direction parallel to the substrate is described as a "horizontal direction".

Here, when the "vertical direction" is defined as 0° with respect to the substrate, a light beam which is in the opposite direction to the light beam emitted from the light emitting portion through the lens at an arbitrary angle is referred to as "incident light". This represents the optical path of light tracing the emitted light in the opposite direction. The region where the incident light intersects the light emission region and its periphery region is defined as an incident region. Note that the drawings are simplified here for the descriptive convenience. Various members, such as electrodes, other than the microlens 7 and the light emitting portion 30 may be provided on the substrate.

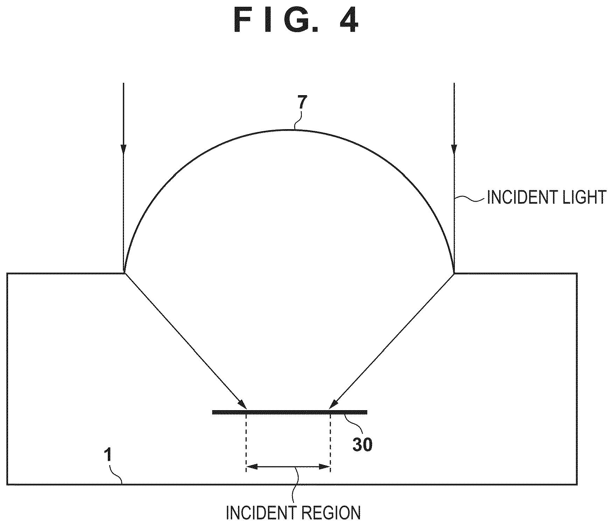

The incident light and the incident region will be described with reference to Figs. 3 and 4. Fig. 3 shows a section taken along a plane perpendicular to the substrate 1 and passing through the vertex in the curved surface portion of the microlens. Fig. 3 shows a state in which, among light beams extracted from the light emitting portion 30 via the microlens in a normal direction perpendicular to the substrate, the light beam extracted from the outermost peripheral portion of the light emitting portion 30 is emitted in the normal direction. To the contrary to the direction of light shown in Fig. 3, Fig. 4 shows the incident light that enters while tracing, in the opposite direction, the light beam emitted from the light emission region shown Fig. 3. Here, the region where the incident light intersects the light emission region and its periphery region is defined as the incident region.

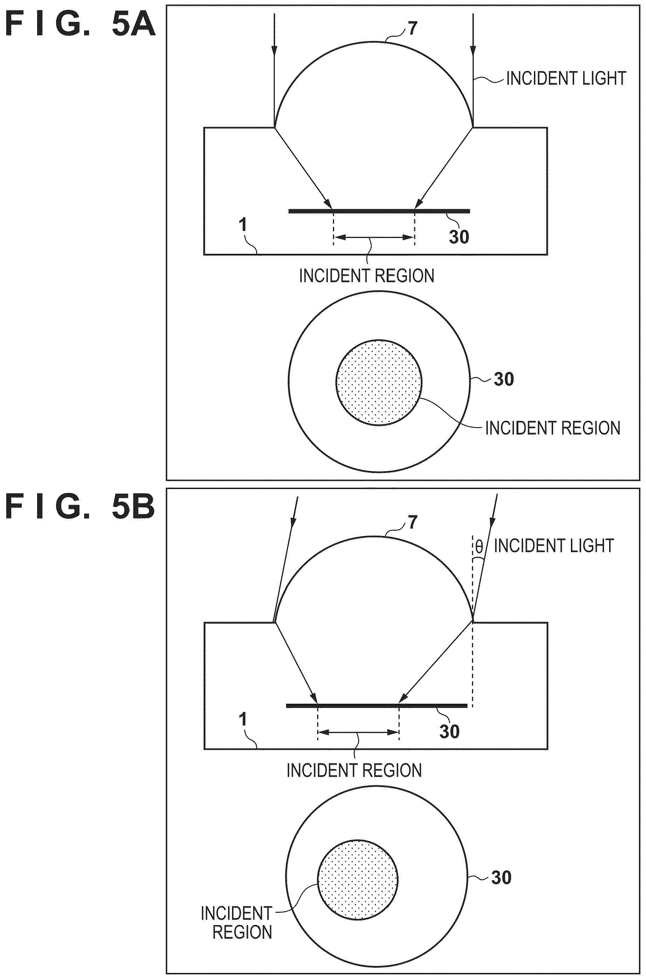

Next, with reference to Fig. 5A to 7B, the relationship between the light emission region and the incident region will be described. Fig. 5A shows a case in which the incident region is inside the light emission region, and the area of the incident region is smaller than the area of the light emission region (light emitting portion 30). Fig. 5B shows a state in which incident light enters obliquely at an angle θ with respect to the normal direction of the substrate. In this case, light emitted from the light emitting portion can be emitted while tracing, in the opposite direction, the incident light shown in Fig. 5B. In this example, light from the light emitting portion can be emitted in the direction of the angle θ over the entire circumference of the microlens 7. As shown in Fig. 5B, since the light from the light emitting portion 30 can be used efficiently, even when an observer views the light emitting element from the angle θ, the light can reach the observer without being lost.

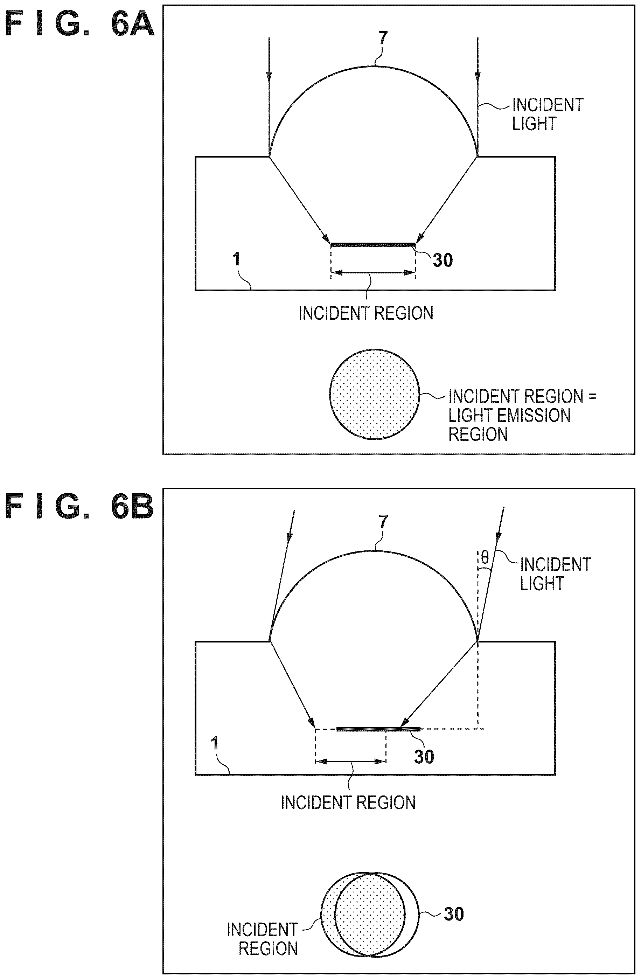

Fig. 6A shows a case in which the incident region and the light emission region overlap and are substantially equal. When incident light enters obliquely at the angle θ with respect to the normal direction of the substrate, a part of the incident region exists outside the light emission region as shown in Fig. 6B. That is, when the light emitting element is observed from a position tilted by the angle θ, the light beams from the light emission region do not enter the microlens as effectively as in the case where the light emitting element is observed from the vertical direction. Since the incident region protruding from the light emission region is lost, the view angle characteristic can be degraded.

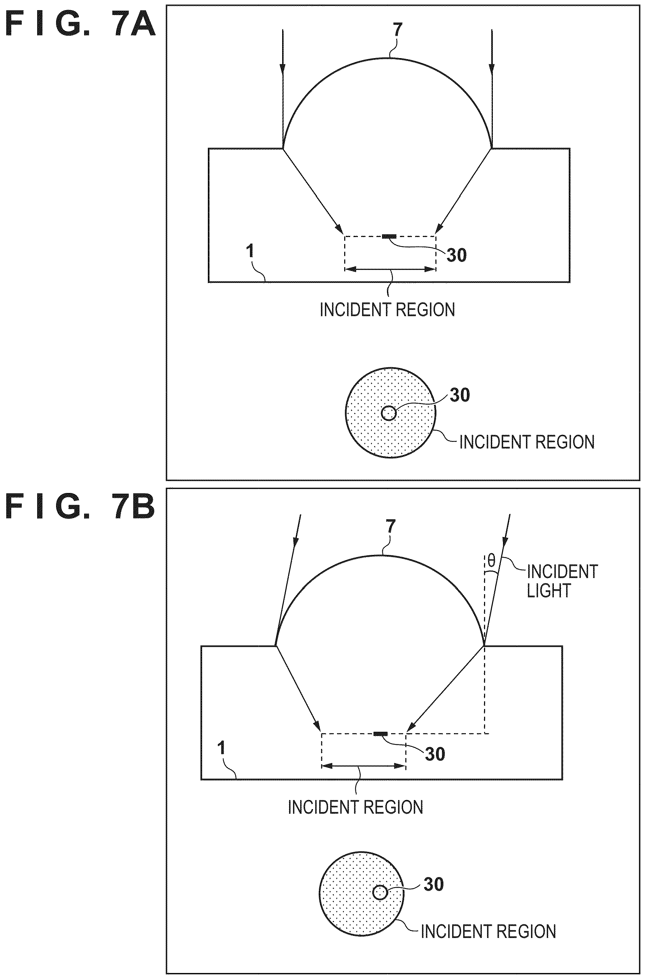

Fig. 7A shows an example in which the light emission region is included in the incident region, and the area of the incident region is larger than the area of the light emission region. In this example as well, when incident light enters obliquely at the angle θ with respect to the normal direction of the substrate, since the light emission region is inside the incident region, the light beams from the light emitting portion can be used effectively. Therefore, the view angle characteristic can be improved. In this manner, in the case shown in Fig. 5A, Fig. 5B, Fig. 7A, or Fig. 7B, the view angle characteristic can be improved.

It is known that the view angle characteristic is improved if the above-described interference order is low. In a light emitting device, the interference order may be different for each light emitting element. In that case, the view angle characteristic can be different for each light emitting element. However, the view angle characteristic can be improved based on the above-described relationship between the incident region and the light emission region. In other words, it is possible to suppress the difference in view angle characteristic between pixels having different interference orders.

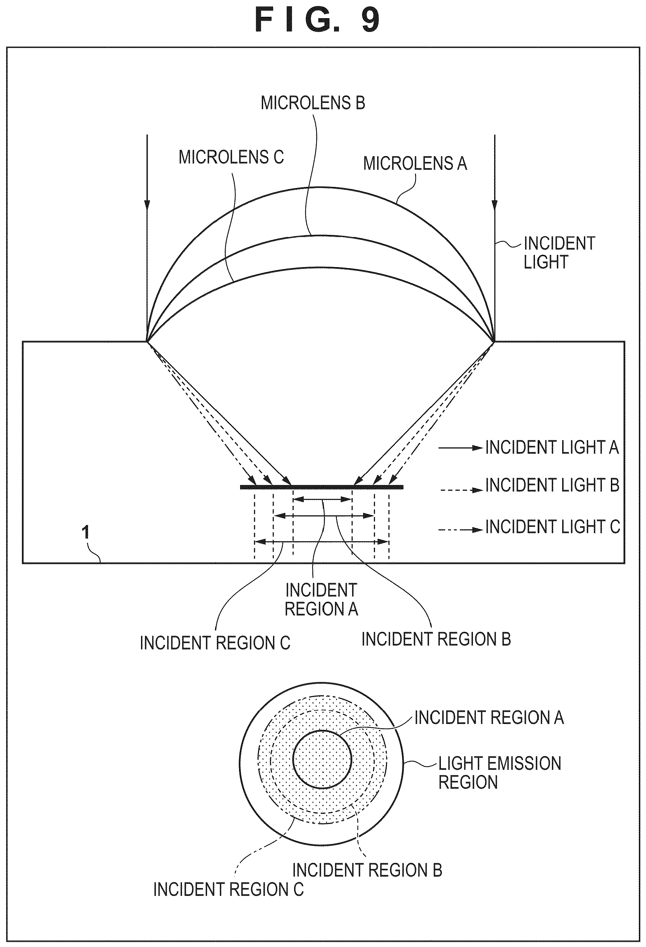

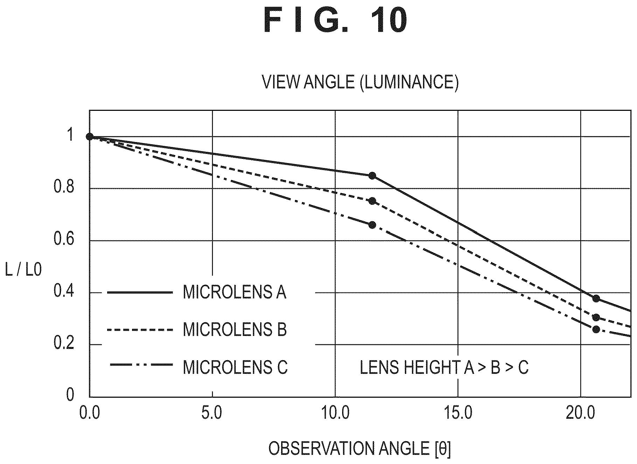

More specifically, in a light emitting element having a high interference order, the relationship between the light emitting portion (light emission region) and the incident region is set to the relationship shown in Fig. 5A or Fig. 5B. This can be implemented by changing the height of the microlens 7. As shown in Fig. 9, as the height of the microlens 7 decreases in the order of A, B, and C, the incident region increases in the order of A, B, and C. Hence, by decreasing the incident region of light beams entering the light emitting portion 30 from the normal direction to the substrate 1, the view angle characteristic can be improved. It is also found from the calculation result shown in Fig. 10 that the view angle characteristic is improved. Here, the abscissa of Fig. 10 represents the observation angle with respect to the light emitting element, and the ordinate represents the change in luminance relative to the observation angle. Here, as an example, the area of the incident region was decreased by increasing the height of the lens.

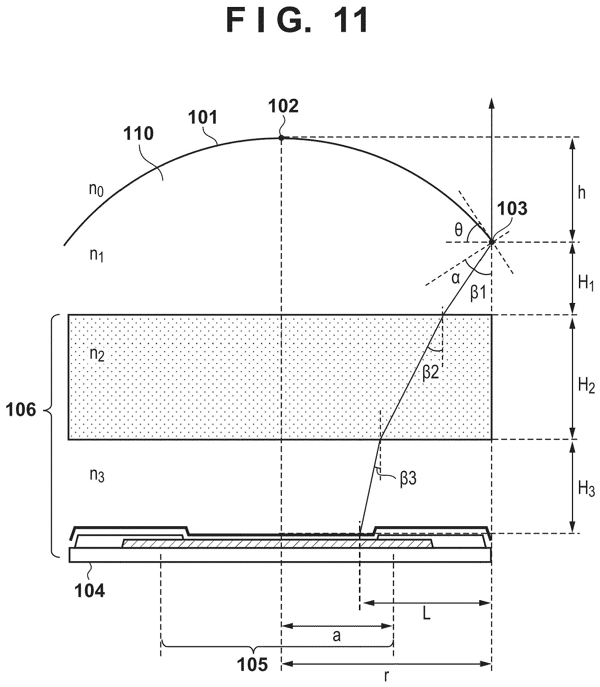

With reference to Fig. 11, the area of the incident region and the area of the light emitting portion will be described below in detail. The upper surface of a lens 110 has a convex curved surface 101 in a direction away from the main surface of a substrate 104. A vertex 102 of the curved surface 101 is a portion of the curved surface 101 forming the upper surface of the lens 110 that is furthest from the main surface of the substrate 104. In the configuration shown in Fig. 11, an end portion 103 of the curved surface 101 is a portion of the lens 110 contacting a medium layer 106. For example, if the outer edge portion of the lens 110 is gentle, the end portion 103 of the curved surface 101 may be a set of inflection points where the upper surface of the lens 110 changes from the convex curved surface 101 to the concave shape. Alternatively, the end portion 103 may be a set of points where the angle (inclination angle $\theta$) between the tangent of the curved surface 101 and the main surface of the substrate is maximum. Fig. 11 shows a section in the normal direction to the main surface of the substrate 104, which passes through the vertex 102 of the curved surface 101 forming the upper surface of the lens 110.

As shown in Fig. 11, the difference in height between the vertex 102 and the end portion 103 in the normal direction to the main surface of the substrate 104 is defined as h [$\mu$m] (to be sometimes referred to as the "distance h" hereinafter). The distance between the vertex 102 and the end portion 103 in an orthogonal projection to the main surface of the substrate 104 is defined as r [$\mu$m] (to be sometimes referred to as the "distance r" hereinafter). The difference in height between the end portion 103 and a light emitting portion 105 in the normal direction to the main surface of the substrate 104 is defined as H [$\mu$m] (to be sometimes referred to as the "distance H" hereinafter). The distance from the center to the end portion of the light emitting portion 105 is defined as a [$\mu$m] (to be sometimes referred to as the "distance a" hereinafter).

At the end portion 103 of the curved surface 101, the inclination angle $\theta$ of the lens 110 can be largest on the curved surface 101. If the curved surface 101 is a spheric surface, the inclination angle $\theta$ at the end portion 103 is given by $\sin\theta = 2rh/(r^2 + h^2)$ using the distance h and the distance r. Consider a light beam which is refracted at a point on the curved surface 101 with the inclination angle $\theta$, and extracted in the front direction (the normal direction to the main surface of the substrate 104). An incident angle $\alpha$ to the curved surface 101 is given by $n1\cdot\sin\alpha = n0\cdot\sin\theta$ according to Snell's law, using a refractive index n0 of the layer on the light-extraction side at the curved surface 101 and a refractive index n1 of the layer (the lens 110 in this configuration example) on the light emitting portion side at the curved surface 101. An angle $\beta1$ of the light beam with respect to the front direction inside the layer (the lens 110 in this configuration example) on the light emitting portion side at the curved surface 101 is given by $\beta1 = |\theta - \alpha|$.

When the distance that a light beam (the light beam extracted in the front direction) traveling from the light emitting portion 105 to the end portion 103 of the curved surface 101 at an angle $\beta$ travels in a direction parallel to the main surface of the substrate 104 is defined as L, the area of the incident region is given by $\pi(r - L)^2$, and the area of the light emitting portion is given by $\pi a^2$.

Considering the refraction at the interface of each layer provided between the light emitting portion and the lens, the distance L is given by calculating the angle of the light beam in each layer. More specifically, in a case where N layers (three layers in the example shown in Fig. 11) including the microlens layer are provided, assuming that the microlens layer is the first layer, and the ith layer in the stacking order from the first layer has a refractive index ni, a light beam angle $\beta i$ in the ith layer is given by:

$$ni\cdot\sin\beta i = n1\cdot\sin\beta1 \qquad\qquad ...(1)$$

A distance Li that the light beam travels in the direction parallel to the main surface of the substrate in each layer is given by $Li = H_i\cdot\tan\beta i$, using the above-described light beam angle $\beta i$ in each layer. The distance L is given by adding the distances Li in each layer from i = 1 to i = N, as expressed by the following equation (2). Here, $H_i$ is the height of the ith layer in the normal direction to the main surface of the substrate 104. That is, if there are N layers, $H = H_1 + H_2 + H_3 + ... + H_N$.

$$L = H1\cdot\tan\beta1 + H2\cdot\tan\beta2 + ... + H_N\cdot\tan\beta_N \qquad\qquad ...(2)$$

From the above, it can be understood that $\pi(r - L)^2 < \pi a^2$ holds if the area of the incident region is smaller than the area of the light emitting portion, and $\pi a^2 < \pi(r - L)^2$ holds if the area of the incident region is larger than the area of the light emitting portion.

In a light emitting element having a high interference order, the relationship between the area of the light emitting portion and the area of the incident region may be set to the relationship as shown in Fig. 7A. In this case, by decreasing the height of the lens, the area of the incident region may be increased so that the incident region includes the light emission region. To summarize, since a light emitting element having a low interference order has a better view angle characteristic than a light emitting element having a high interference order, it is advantageous to provide a configuration for improving the view angle characteristic in the light emitting element having a high interference order. That is, for the light emitting element having a high interference order, the larger difference between an area $S_2$ of the incident region and an area $S_2'$ of the light emission region is advantageous in improving the view angle characteristic. In the light emitting element having a low interference order, the difference between an area $S_1$ of the incident region and an area $S_1'$ of the light emission region may be smaller than that in the light emitting element having a high interference order. This relationship can be expressed as $|S_1 - S_1'| < |S_2 - S_2'|$.

In another viewpoint, in a pixel having a low interference order and a pixel having a high interference order, the distances, each of which a light beam emitted from the light emitting portion, refracted at the end portion of the lens, and extracted in the front direction travels from the light emitting portion to the lens in a direction parallel to the main surface of the substrate, are defined as $L_1$ and $L_2$, respectively. The distances, each from the center of the light emitting portion to the end portion. are defined as $a_1$ and $a_2$, respectively. The distances, each from the vertex to the end portion of the lens in the direction parallel to the main surface of the substrate, are defined as $r_1$ and $r_2$, respectively. In this case, by satisfying a relationship expressed by $|\pi(r_1 - L_1)^2 - \pi a_1^2| < |\pi(r_2 - L_2)^2 - \pi a_2^2|$, the difference in view angle characteristic between the pixels having different interference orders can be suppressed.

In another viewpoint, it can be understood that, by satisfying a relationship expressed by $|r_1 - L_1 - a_1| < |r_2 - L_2 - \pi a_2|$, the difference in view angle characteristic between the pixels having different interference orders can be suppressed.

(Optical Resonance Structure)

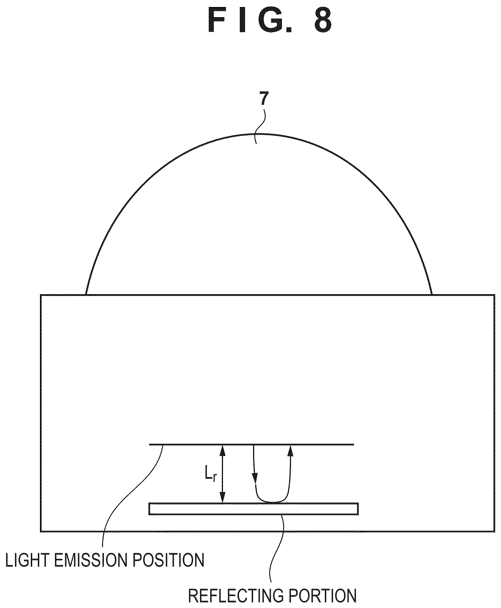

Next, the optical resonance structure will be described with reference to Fig. 8. Here, the position of the light emitting portion 30 is defined as the light emission position. A light emitting element having an optical resonance structure forms a resonator between a light emission position and a reflecting portion where light is reflected. The reflecting portion is a reflective layer provided at a predetermined position. A lower electrode may be the reflective layer, or the reflective layer may be provided at the predetermined position if the lower electrode is a transparent electrode. In an example of the resonance structure, to set the appropriate optical distance between the reflecting portion and the light emission position, the following equation (3) is satisfied:

$$Lr = (2 \times m - (\phi r/\pi)) \times (\lambda/4) \qquad \qquad ...(3)$$

In equation (3), Lr is the optical distance (optical path length) considering the refractive index between the reflecting portion and the light emission position, $\lambda$ is the peak wavelength of the emission spectrum emitted by the light emitting element, $\phi r$ is the phase shift generated when light of the wavelength $\lambda$ is reflected at the reflecting portion, and m is an integer of 0 or more. Here, m can be called a light constructive interference order. An organic light emitting element having a high interference order of the resonance structure has the longer distance between the light emitting position and the reflecting portion and a higher constructive interference order than a light emitting element having a low interference order.

Considering the width of the peak wavelength $\lambda$ of the emission spectrum emitted by the light emitting element, structural constraints, accuracy, and the like, the allowable range of the optical path length Lr may be within a width of about $\lambda/8$ or about 20 nm. Considering the allowable range, Lr falls within the range expressed:

$$(2 \times m - (\phi r/\pi)) \times (\lambda/4) - \lambda/8 < Lr < (2 \times m - (\phi r/\pi)) \times (\lambda/4) + \lambda/8 \qquad ...(4)$$

Note that the light emission position may be the interface of the light emitting layer 31 on the lower electrode 2 side. Alternatively, the light emission position may be the interface of the light emitting layer 31 on the upper electrode 4 side. Considering the allowable range of $\lambda/8$ described above, an effect of intensifying light can be obtained even if the light emission position is set as expressed in equation (4).

(Configuration of Light Emitting Device)

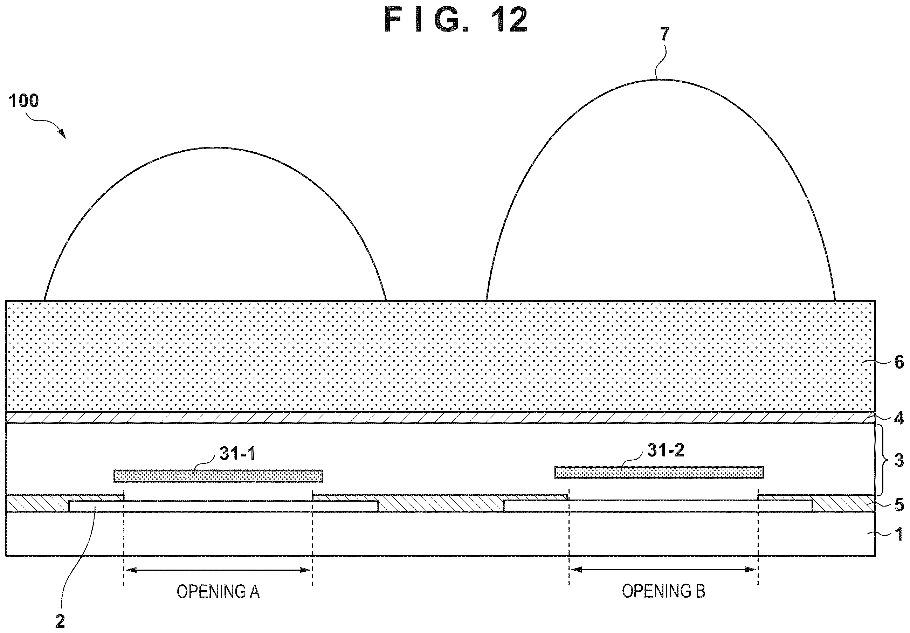

Next, with reference to Figs. 12 to 21, the configuration of the light emitting device according to the embodiment will be described. Here, consider the light emitting device in which the light emitting element including the opening A is a blue pixel and the light emitting element including the opening B (having a high interference order) is a green pixel. However, the colors of the pixels are not limited to this.

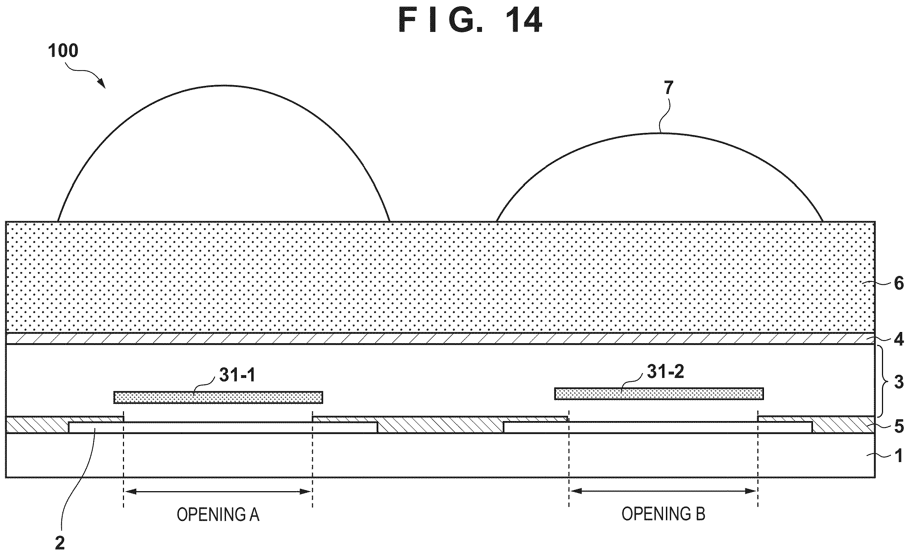

The structure advantageous in improving the view angle characteristic will be described with reference to Fig. 12 and Fig. 14. These are examples in which the opening A and the opening B have substantially the same size. In this case, as shown in Fig. 12, the height of the microlens 7 located above the opening B is made larger than the height of the microlens 7 located above the opening A, thereby including the incident region in the light emission region. As a result, the relationship between the incident region and the light emission region as shown in Fig. 5A or Fig. 5B is obtained, and the view angle characteristic can be improved. Alternatively, as shown in Fig. 14, the height of the microlens located above the opening B is made smaller than the height of the microlens located above the opening A. As a result, the relationship between the incident region and the light emission region as shown in Fig. 7A or Fig. 7B is obtained, and the view angle characteristic can be improved. In a case where the relationship between the light emission region and the incident region is as shown in Fig. 6A or Fig. 6B, the view angle characteristic can be improved by adopting either the configuration shown in Fig. 12 or the configuration shown in Fig. 14.

With reference to Figs. 12 to 15, structures advantageous in improving the view angle characteristic will be described in more detail. In each example, the area $S_1'$ of the opening A of the light emitting element having a low interference order and the area $S_2$' of the opening B of the light emitting element having a high interference order satisfy $S_1$' = $S_2$'.

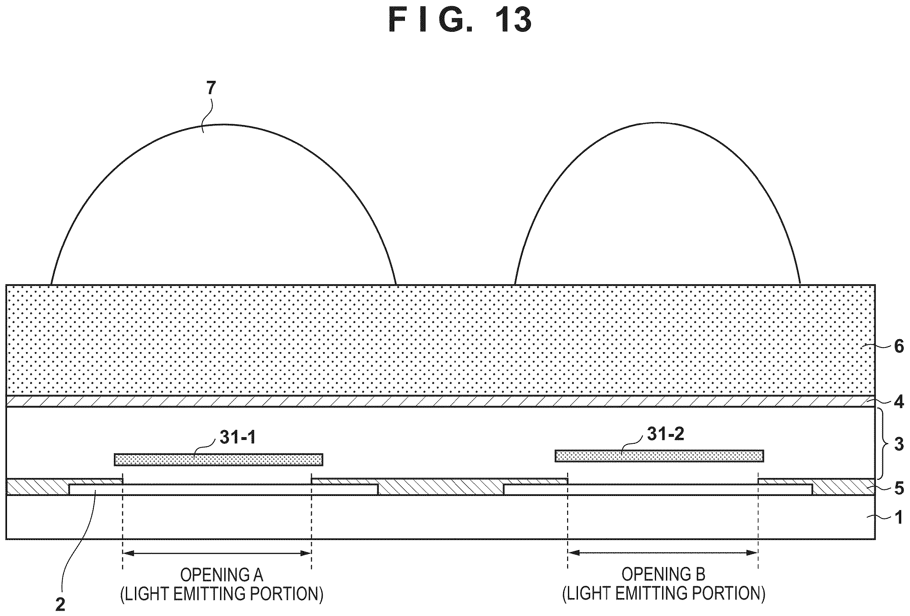

If $S_1 < S_1$', as shown in Fig. 12, the height of the microlens 7 located above the opening B is made larger than the height of the microlens 7 located above the opening A. Alternatively, as shown in Fig. 13, the radius of the microlens 7 located above the opening B is made smaller than the radius of the microlens 7 located above the opening A to satisfy $S_2 < S_1$. In this case, the relationship expressed by $|S_1 - S_1'| < |S_2 - S_2'|$ is set, and the difference in view angle characteristic between the opening A and the opening B can be suppressed.

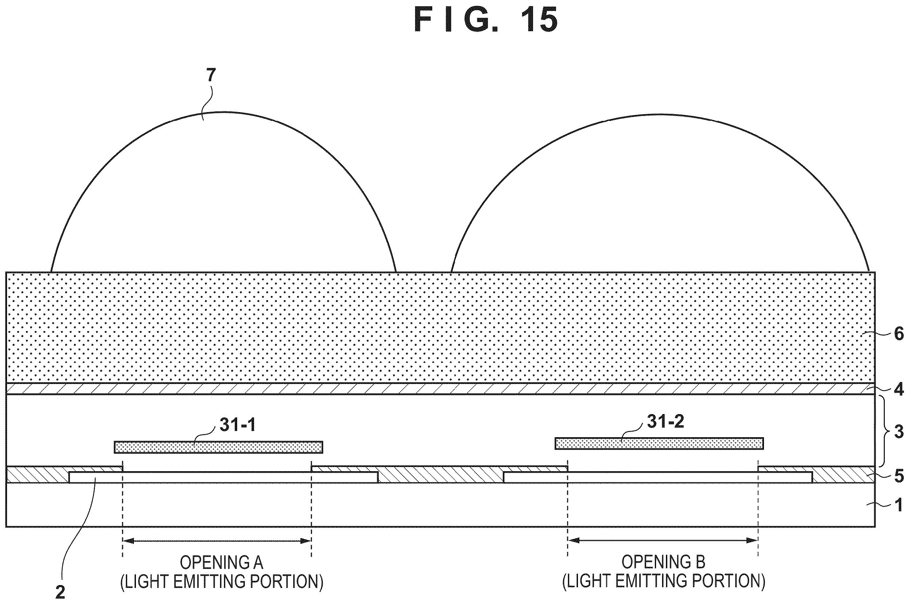

Alternatively, as shown in Fig. 14, the height of the microlens located above the opening B is made smaller than the height of the microlens located above the opening A. Alternatively, the radius of the microlens 7 located above the opening B is made larger than the radius of the microlens 7 located above the opening A to satisfy $S_1 < S_2$. In this case, since the difference between the incident region and the light emission region becomes larger than that of the opening A, the relationship expressed by $|S_1 - S_1'| < |S_2 - S_2'|$ is set, and the difference in view angle characteristic between the opening A and the opening B can be suppressed. As shown in Fig. 15, if the microlenses respectively located above the opening A and the opening B have the same height, the difference in view angle characteristic between the opening A and the opening B can be suppressed even by making the radius of the microlens located above the opening B larger than the radius of the microlens located above the opening A.

If the relationship between the incident region and the light emission region satisfies $S_1 = S_1$', the difference in view angle characteristic between the opening A and the opening B can be suppressed by adopting any of the configurations shown in Figs. 12 to 15.

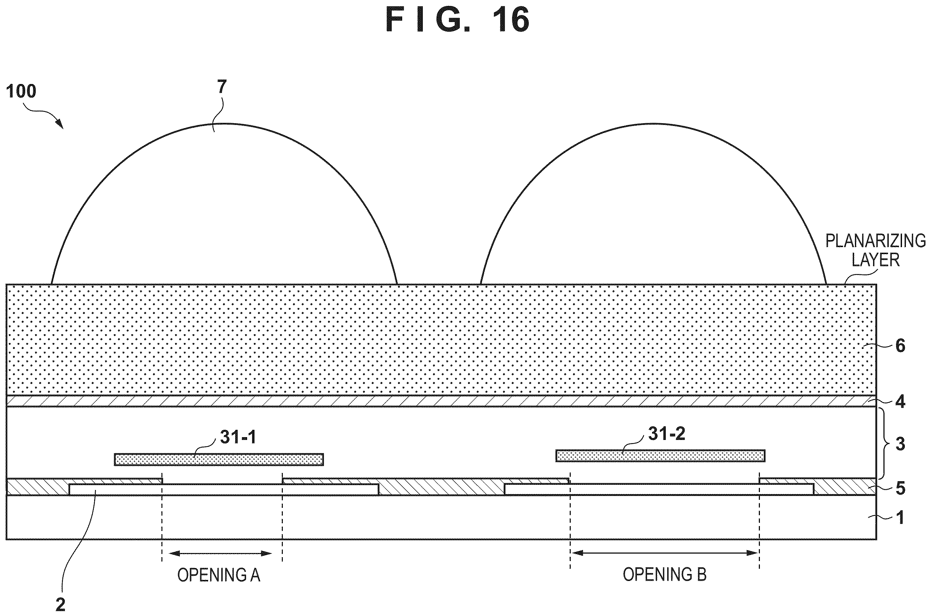

In the examples described above, if the opening A and the opening B have substantially the same area, the view angle can be improved by changing the height of the microlens. In addition, the view angle can also be improved by changing the radius of the microlens. If the light emitting elements having different interference orders respectively include the microlenses having the same shape, the view angle characteristic can be improved by making different areas of two openings of the light emitting elements having different interference orders. More specifically, as shown in Fig. 16, the area of the opening B of the light emitting element having a high interference order is made larger than the area of the opening A of the light emitting element having a low interference order. As a result, the relationship between the incident region and the light emission region as shown in Fig. 5A or Fig. 5B can be obtained, and the view angle characteristic can be improved.

A more specific description will be given. In the examples shown in Figs. 12 to 15, if the opening A and the opening B have substantially the same area, the difference in view angle characteristic between the opening A and the opening B can be suppressed by changing the height or radius of the microlens. As still another method, there is a case where the area $S_1$ of the incident region of the opening A of the light emitting element having a low interference order and the area $S_2$ of the incident region of the opening B of the light emitting element having a high interference order satisfy $S_1 = S_2$.

More specifically, if $S_1 < S_1$', as shown in Fig. 16, the area of the opening B is made larger than the area of the opening A of the light emitting element having a low interference order to set $S_1' < S_2$'. Since the difference between the incident region and the light emission region becomes larger than that of the opening A, the relationship expressed by $|S_1 - S_1'| < |S_2 - S_2'|$ is set, and the difference in view angle characteristic between the opening A and the opening B can be suppressed.

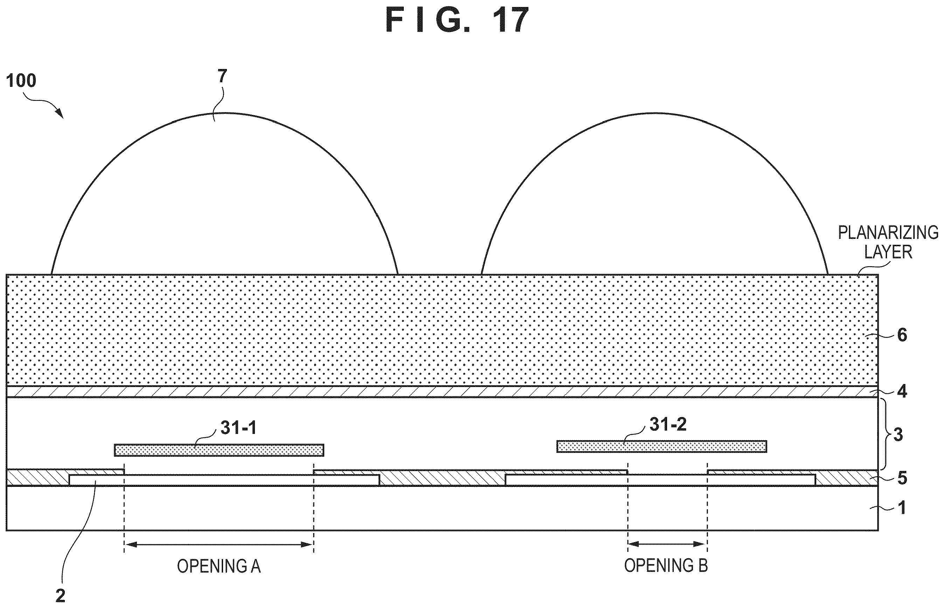

Alternatively, as shown in Fig. 17, the area of the opening B of the light emitting element having a high interference order is made smaller than the area of the opening A of the light emitting element having a low interference order. As a result, the relationship between the incident region and the light emission region as shown in Fig. 7A or Fig. 7B can be obtained, and the view angle characteristic can be improved. If the relationship between the light emission region and the incident region is as shown in Fig. 6A or Fig. 6B, the view angle characteristic can be improved by adopting either the configuration shown in Fig. 16 or the configuration shown in Fig. 17.

A more specific description will be given. As shown in Fig. 17, the area of the opening B of the light emitting element having a high interference order is made smaller than the area of the opening A of the light emitting element having a low interference order to set $S_1' > S_2$'. By setting such a relationship, the difference between the incident region and the light emission region becomes larger than that of the opening A, and the relationship expressed by $|S_1 - S_1'| < |S_2 - S_2'|$ is set. With this, the difference in the view angle characteristic between the opening A and the opening B can be suppressed. If the relationship between the light emission region and the incident region is expressed as $S_1 = S_1$', the difference in view angle characteristic between the opening A and the opening B can be suppressed by adopting either the case shown in Fig. 16 or the case shown in Fig 17.

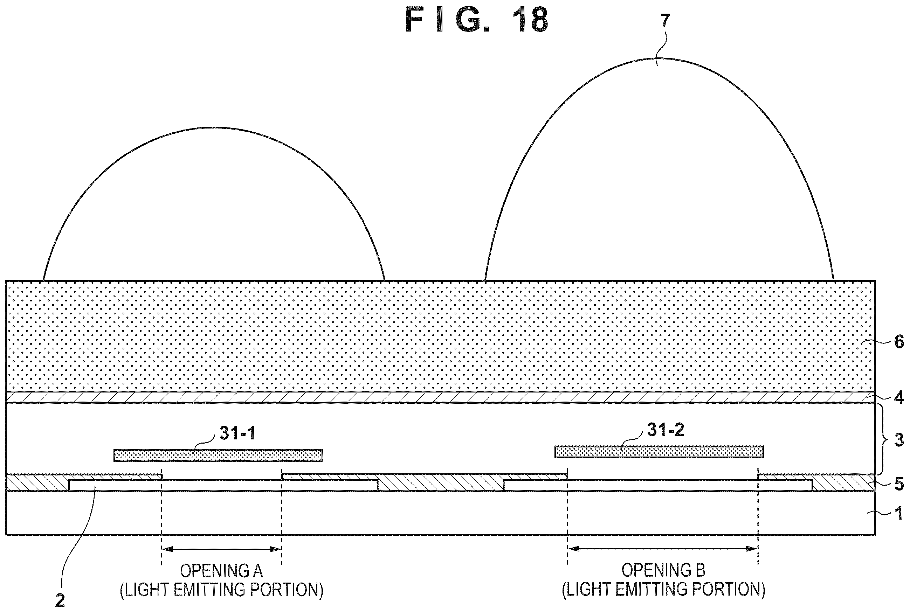

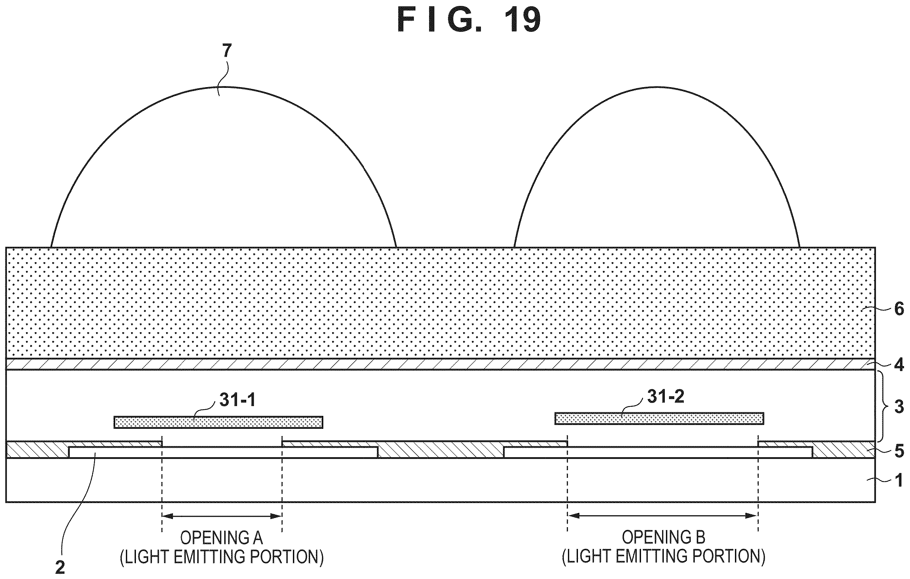

Next, embodiments in which the configurations shown in Figs. 12 to 17 are combined will be described. First, if $S_1 < S_1$', as shown in Figs. 18 and 19, the area of the opening B is made larger than the area of the opening A of the light emitting element having a low interference order to set $S_1' < S_2$'. Furthermore, as shown in Fig. 18, the height of the microlens located above the opening B is made larger than the height of the microlens located above the opening A. Alternatively, as shown in Fig. 19, the radius of the microlens 7 located above the opening B is made smaller than the radius of the microlens 7 located above the opening A to set $S_2 < S_1$. As a result, the relationship expressed by $|S_1 - S_1'| < |S_2 - S_2'|$ is set, and the difference in view angle characteristic between the opening A and the opening B can be suppressed.

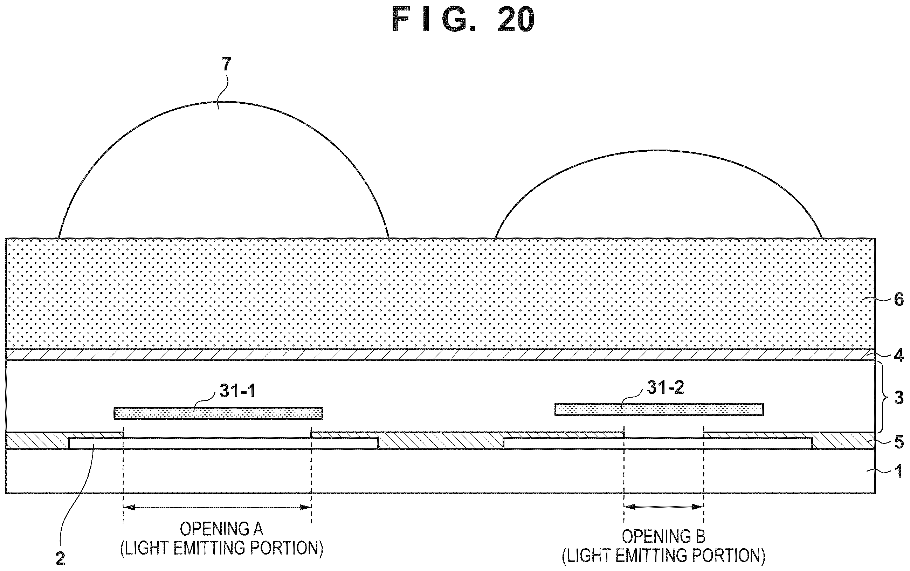

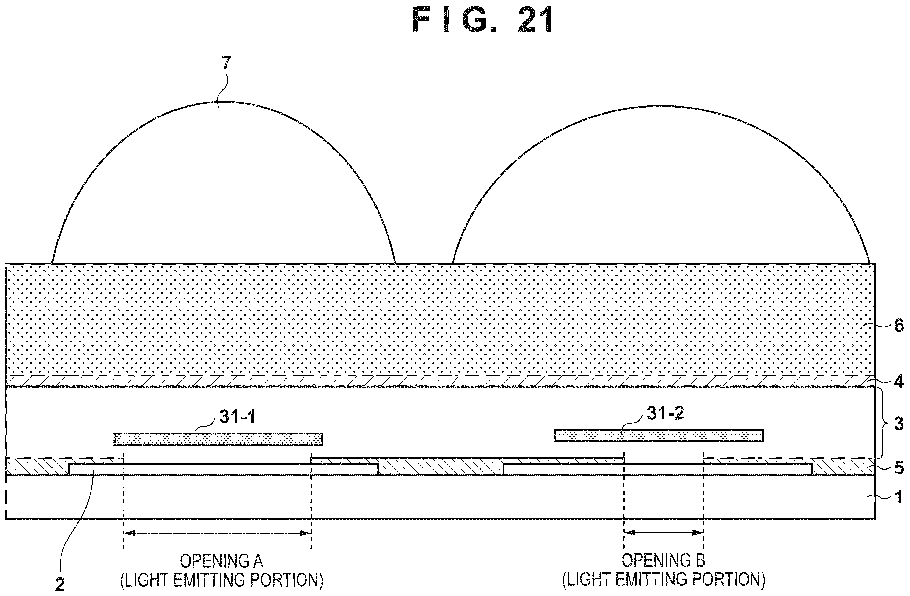

Alternatively, as shown in Figs. 20 and 21, the area of the opening B is made smaller than the area of the opening A of the light emitting element having a low interference order to set $S_1' > S_2'$. Furthermore, as shown in Fig. 20, the height of the microlens located above the opening B is made smaller than the height of the microlens located above the opening A. Alternatively, as shown in Fig. 21, the radius of the microlens 7 located above the opening B is made larger than the radius of the microlens 7 located above the opening A to set $S_2 > S_1$. As a result, the relationship expressed by $|S_1 - S_1'| < |S_2 - S_2'|$ is set, and the difference in view angle characteristic between the opening A and the opening B can be suppressed.

In the examples shown in Figs. 12 to 19 described above, the cases have been considered where the relationship expressed by $S_1 < S_1'$ holds. However, even if $S_1 > S_1'$, by setting the relationship expressed by $|S_1 - S_1'| < |S_2 - S_2'|$, the difference in view angle characteristic between the opening A and the opening B can be suppressed.

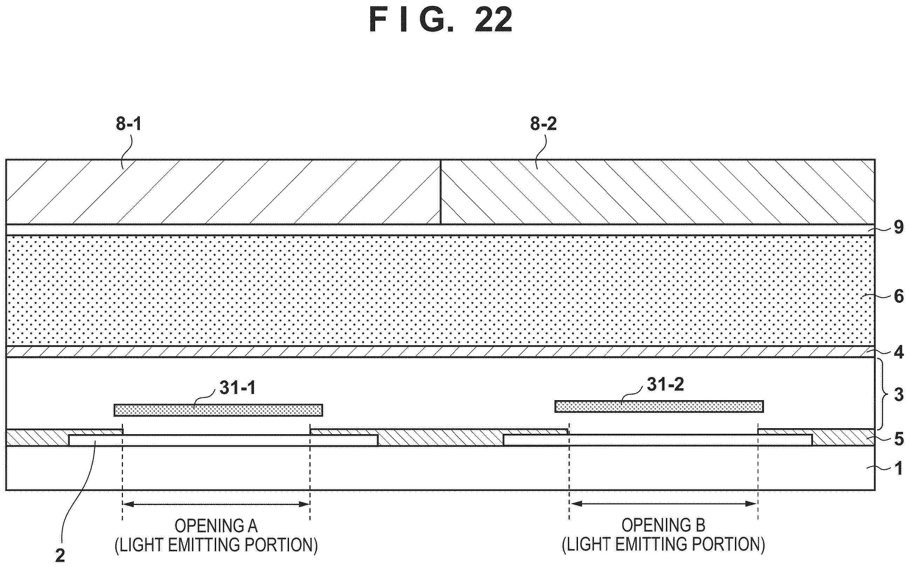

Note that, also in the configurations shown in Figs. 22 to 26, by arranging microlenses above color filters, and setting the relationship between the interference orders of the openings, the shapes of the microlenses, and the relationship between the openings similar to those shown in each of Figs. 12 to 21, an effect similar to that of the configuration shown in each of Figs. 12 to 21 can be obtained.

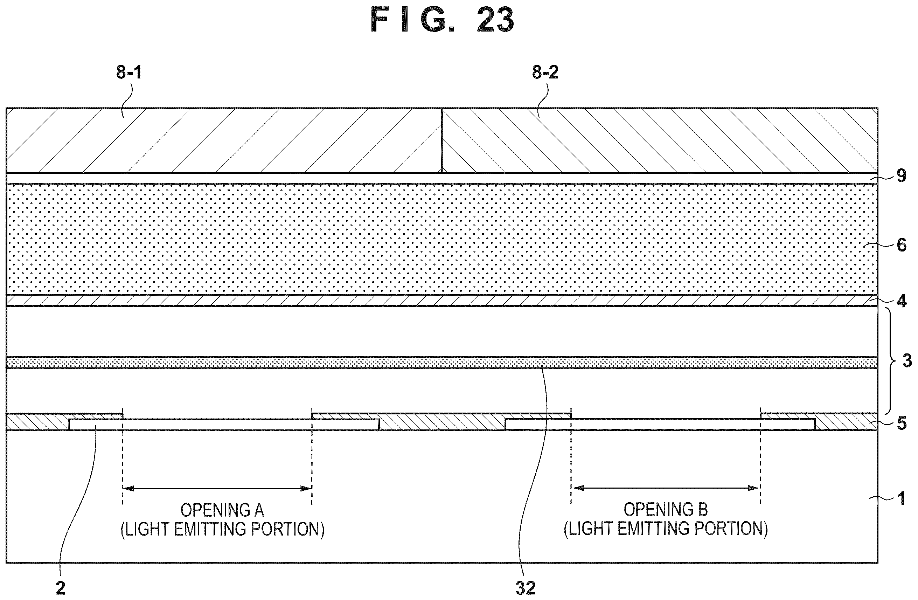

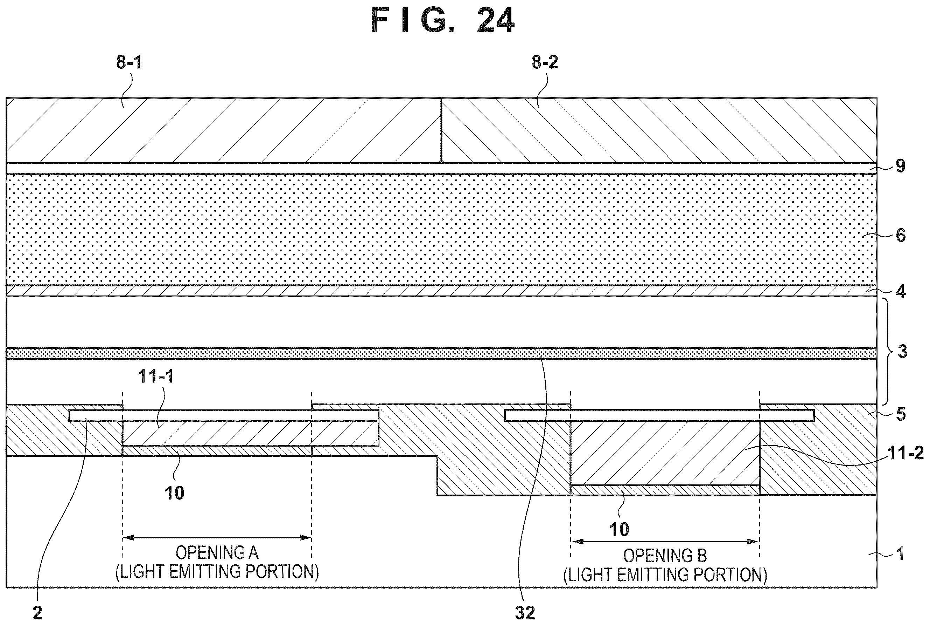

The example shown in Fig. 22 is the configuration in which a color filter 8-1 and a color filter 8-2 are arranged in the example shown in each of Figs. 12 to 21, and a further improvement in color purity or the like can be expected. A planarizing layer 9 may be provided between the color filters 8-1 and 8-2 and the protective layer 6. The example shown in Fig. 23 is the configuration in which the film formation area of a light emitting layer 32 is not divided for each light emitting element, and the light emitting layer 32 exists as a common layer. This contributes simplification of the vapor deposition process. Furthermore, in the example shown in Fig. 24, reflective layers 10 and optical adjustment layers 11-1 and 11-2 are arranged on the lower electrode side. This facilitates the optimal interference design for each opening, compared to the example shown in Fig. 23.

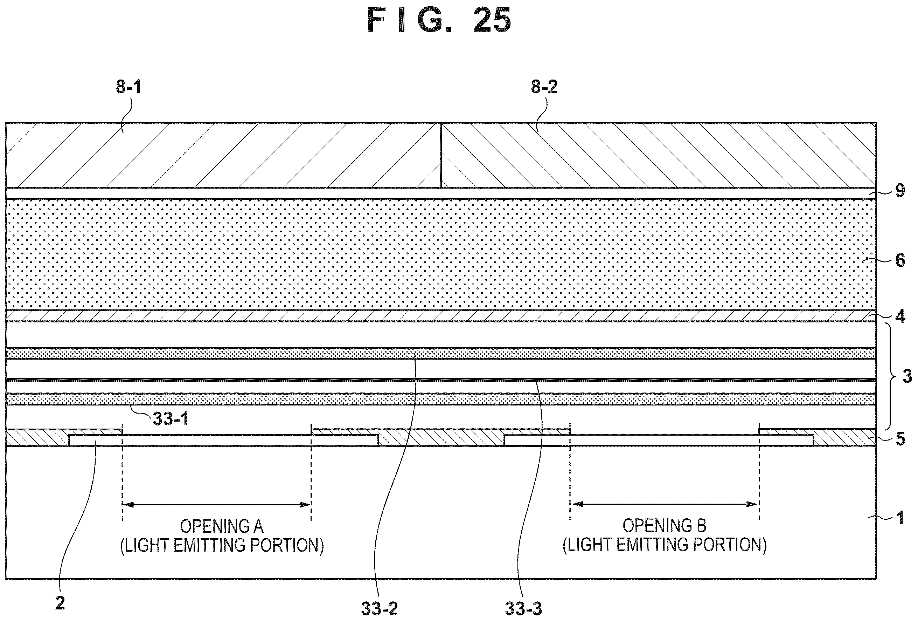

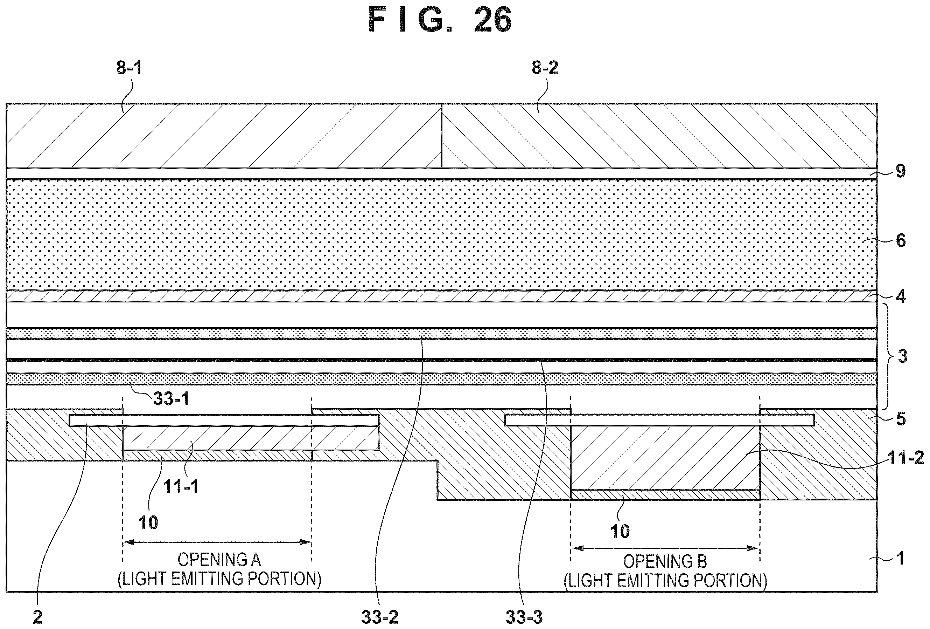

Fig. 25 shows an example of the tandem configuration including a charge generation layer (CGL) 33-3 between a light emitting layer 33-1 and a light emitting layer 33-2. This can be expected to improve the light emission efficiency or the like. In the example shown in Fig. 26, the optical adjustment layers are arranged on the lower electrode side. This facilitates the optimal interference design for each opening, compared to the example shown in Fig. 25. Here, the opening A includes the light emitting layer 33-1 and the light emitting layer 33-2 separated by the charge generation layer, and has an optical resonance structure having an optical path length A with one of these light emitting layers. The opening B includes the light emitting layer 33-1 and the light emitting layer 33-2 separated by the charge generation layer, and has an optical resonance structure having an optical path length B with the other light emitting layer not used with the opening A. It is sufficient that both the optical path length A and the optical path length B approximately satisfy the relationship expressed by equation (3) and fall within the range expressed by equation (4).

The light emitting device in which the light emitting element including the opening A has a lower interference order than the light emitting element including the opening B has been described as the example. The light emitting element having a low interference order has a larger view angle than the light emitting element having a high interference order. Hence, the need to care about the relationship between the area of the light emission region and the area of the incident region is lower in the light emitting element having a low interference order than in the light emitting element having a high interference order.

To summarize the above, the following can be said. That is, the area of the incident region and the area of the light emission region of a light emitting element having a lower interference order are defined as $S_1$ and $S_1'$, respectively, and the area of the incident region and the area of the light emission region of a light emitting element having a high interference order are defined as $S_2$ and $S_2'$, respectively. In this case, the absolute value of the difference between $S_1$ and $S_2$ and the absolute value of the difference between $S_1'$ and $S_2'$ are compared. If the areas $S_1'$ and $S_2'$ of the light emission regions are substantially the same, the areas $S_1$ and $S_2$ of the incident regions may be differentiated by changing the height of the microlens, so that the difference between $S_1$ and $S_2$ increases. Accordingly, a relationship expressed by $|S_1 - S_2| > |S_1' - S_2'|$ holds. If the areas $S_1$ and $S_2$ of the incident regions are substantially the same, the areas $S_1'$ and $S_2'$ of the light emission regions may be changed, so that a relationship expressed by $|S_1 - S_2| < |S_1' - S_2'|$ holds. Changing the height of the microlens and changing the area of the opening may be combined in the light emitting element having a high interference order.

From the above, by considering the relationship between the area of the incident region and the area of the light emission region, and setting one region to include the other region, the view angle characteristic can be improved. In this case, in the pixel having a high interference order, the ratios of the area of the light emission region and the area of the region where the light having passed through the microlens enters the light emission region and its periphery region are preferably different by about 10% or 30% in terms of the diameter. They are different by about 20% to 40% in the area ratio.

(Manufacturing Method of Light Emitting Device)

A practical example of a method of manufacturing the light emitting device will be described below. In this practical example, the light emitting device includes three kinds of light emitting elements including a red light emitting element with a red light emitting layer, a green light emitting element with a green light emitting layer, and a blue light emitting element with a blue light emitting layer.

First, aluminum was formed on the substrate 1 and patterned, thereby forming the plurality of lower electrodes 2. Next, a plurality of insulating layers were formed to cover the plurality of lower electrodes 2, respectively. The material of the insulating layers was silicon oxide and the film thickness of each insulating layer was 65 nm. The opening was formed to expose the corresponding lower electrode 2 in each insulating layer. Here, the plurality of insulating layers are the insulating layers 5. The shape of the opening was a circular shape having a radius of 0.9 $\mu$m. As described above, the opening of the insulating layer 5 finally exposed the corresponding lower electrode 2 to the light emitting layer 31 corresponding to the lower electrode 2. When viewed from the vertical direction, the size and shape of the opening matched the size and shape of the light emission region of the light emitting layer 31.

Next, the organic compound layer 3 was formed on the lower electrodes 2 (and the insulating layers 5). More specifically, first, a hole injection layer, a hole transport layer, and an electron blocking layer were sequentially formed. At this time, the hole injection layer and the hole transport layer were deposited to cover the lower electrodes 2 corresponding to all the light emitting elements, and the electron blocking layer was deposited three times using a fine mask so as to be separately formed for each of the lower electrodes 2 corresponding to the light emitting elements corresponding to the respective light emission colors. For the purpose of optimizing the optical distance described above, the film thickness of the electron blocking layer was adjusted for each light emission color. Next, a first red light emitting layer, a first green light emitting layer, and a first blue light emitting layer were separately formed by performing deposition using the fine mask three times. Next, a hole blocking layer and an electron transport layer were sequentially formed. The hole blocking layer was formed by adjusting the film thickness of the hole blocking layer for each light emission color, similar to the electron blocking layer. Subsequently, an electron injection layer was formed by lithium fluoride.

Next, an Mg/Ag alloy was formed to a thickness of 10 nm as the upper electrode 4 on the organic compound layer. The ratio of Mg and Ag was 1 : 1. After that, as the protective layer 6, an SiN film with a refractive index of 1.97 was formed to a thickness of 2.1 $\mu$m on the upper electrode 4 by the CVD method.

Next, the microlenses 7 with a refractive index of 1.53 were formed on the protective layer 6 using the exposure process and the developing process. The curved surface portion of the microlens 7 was a part of a spherical surface and, in an example, the distance h in the vertical direction from the vertex (first position) of the curved surface portion to the end (second position) of the curved surface portion was 1.4 $\mu$m and the distance r in the horizontal direction was 1.9 $\mu$m. A portion above the microlens was air with a refractive index of 1. In this case, by considering the height, from the surface of the protective layer 6, of the microlens of the light emitting element having a high interference order, the difference in view angle characteristic between the pixels having different interference orders can be decreased. Alternatively, when exposing the opening in the insulating layer, the size of the opening may be changed. This can improve the display quality.

(Application Examples of Light Emitting Device)

Examples in which the light emitting device 100 according to this embodiment is applied to various kinds of devices will be described.

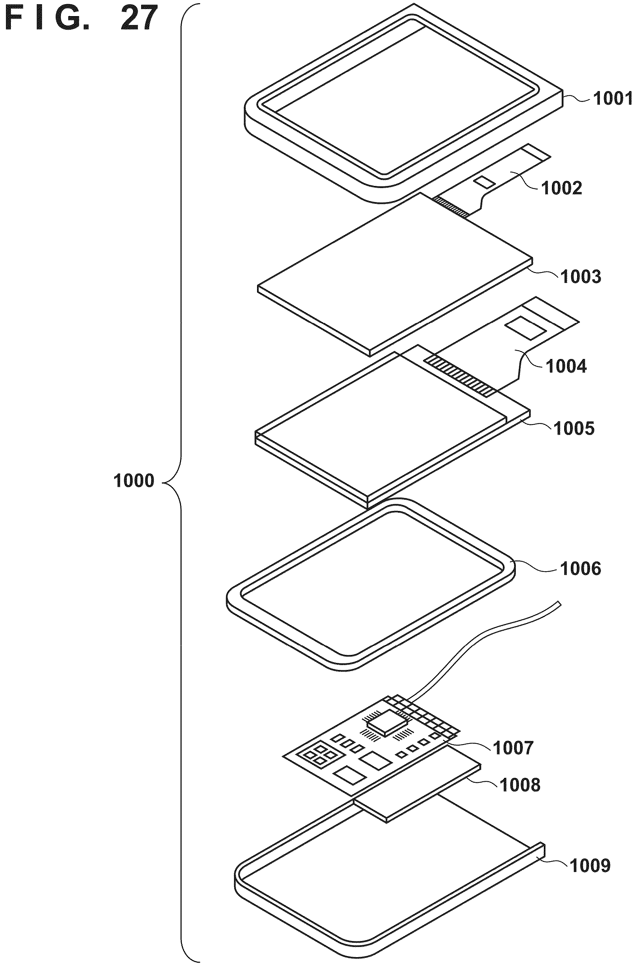

Fig. 27 is a schematic view showing a display device 1000 as an example of a display device according to this embodiment. The display device 1000 can include a touch panel 1003, a display panel 1005, a frame 1006, a circuit board 1007, and a battery 1008 between an upper cover 1001 and a lower cover 1009. The display panel 1005 is a display unit including the light emitting device 100 according to the embodiment, and performs display using light emitted from the light emitting device 100.

Flexible printed circuits (FPCs) 1002 and 1004 are respectively connected to the touch panel 1003 and the display panel 1005. A control circuit including transistors is printed on the circuit board 1007, thereby performing various control operations such as control of the display panel 1005. The battery 1008 is unnecessary if the display device is not a portable apparatus. Even when the display device is a portable apparatus, the battery 1008 may be provided at another position. The display device 1000 may include three kinds of color filters respectively corresponding to red, green, and blue. A plurality of color filters may be arranged using a delta arrangement.

The display device 1000 may be used as a display unit of a portable terminal. At this time, the display device 1000 can have both a display function and an operation function. Examples of the portable terminal are a portable phone such as a smartphone, a tablet, and a head mounted display.

The display device 1000 can be used for a display unit of an image capturing device including an optical unit having a plurality of lenses, and an image sensor for receiving light having passed through the optical unit. The image capturing device can include a display unit for displaying information (an image captured by the image sensor and the like) acquired by the image sensor. In addition, the display unit can be either a display unit exposed outside the image capturing device, or a display unit arranged in the finder. The image capturing device can be a digital camera or a digital video camera.

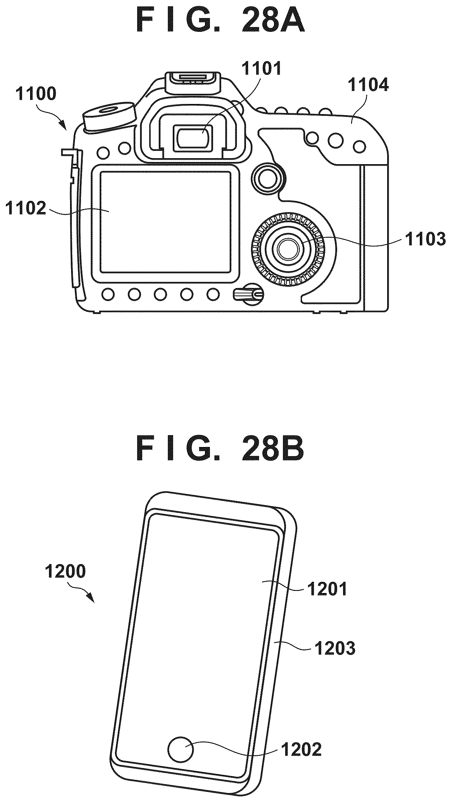

Fig. 28A is a schematic view showing an image capturing device 1100 as an example of an image capturing device according to this embodiment. The image capturing device 1100 may include a viewfinder 1101, a rear display 1102, an operation unit 1103, and a housing 1104. The viewfinder 1101 may include the display device according to this embodiment (a display device that includes the light emitting device 100 according to the embodiment, and performs display using light emitted from the light emitting device 100). In this case, the display device can display not only an image to be captured but also environment information, image capturing instructions, and the like. Examples of the environment information are the intensity and direction of external light, the moving velocity of an object, and the possibility that an object is covered with an obstacle. The rear display 1102 may also include the display device according to this embodiment.

The timing suitable for image capturing is a very short time, so the information is preferably displayed as soon as possible. It is therefore preferable to use the display device using the organic light emitting element having a high response speed. The display device using the organic light emitting element can be used more suitably than a liquid crystal display device or the like in devices that require a high display speed.

The image capturing device 1100 includes an optical unit (not shown). This optical unit has a plurality of lenses, and forms an image of light on an image sensor accommodated in the housing 1104. The focal points of the plurality of lenses can be adjusted by adjusting the relative positions. This operation can also automatically be performed. The image capturing device 1100 may be called a photoelectric conversion device. The photoelectric conversion device can include, as an image capturing method, not a method of sequentially capturing images but a method of detecting the difference from a preceding image, a method of extracting a part of a recorded image, and the like.

Fig. 28B is a schematic view showing an electronic apparatus 1200 as an example of the electronic apparatus according to this embodiment. The electronic apparatus 1200 includes a display unit 1201, an operation unit 1202, and a housing 1203. The display unit 1201 includes the light emitting device 100 according to the embodiment, and performs display using light emitted from the light emitting device 100. In the electronic apparatus 1200, the housing 1203 can accommodate a circuit, a printed board having this circuit, a battery, and a communication unit for performing external communication.

The operation unit 1202 can be a button or a touch-panel-type reaction unit. The operation unit can also be a biometric authentication unit that performs unlocking or the like by authenticating the fingerprint. The electronic apparatus including the communication unit can also be regarded as a communication apparatus. The electronic apparatus may also have a camera function by including a lens and an image sensor. An image captured by the camera function is displayed on the display unit. Examples of the electronic apparatus are a smartphone and a notebook personal computer.

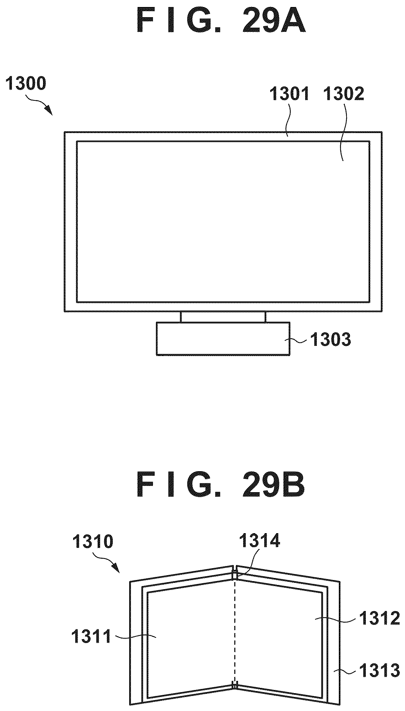

Fig. 29A is a schematic view showing a display device 1300 as an example of the display device according to this embodiment. The display device 1300 is a display device such as a television monitor or a PC monitor. The display device 1300 includes a frame 1301, a display unit 1302, and a base 1303 that supports the frame 1301 and the display unit 1302. The display unit 1302 includes the light emitting device 100 according to the embodiment, and performs display using light emitted from the light emitting device 100. The form of the base 1303 is not limited to the form shown in Fig. 29A. The lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 29B is a schematic view showing a display device 1310 as another example of the display device according to this embodiment. The display device 1310 can be folded, and is a so-called foldable display device. The display device 1310 includes a first display unit 1311, a second display unit 1312, a housing 1313, and a bending point 1314. Each of the first display unit 1311 and the second display unit 1312 includes the light emitting device 100 according to the embodiment, and performs display using light emitted from the light emitting device 100. The first display unit 1311 and the second display unit 1312 can also be one seamless display device. The first display unit 1311 and the second display unit 1312 can be divided by the bending point. The first display unit 1311 and the second display unit 1312 can display different images, and the first display unit 1311 and the second display unit 1312 can also display one image together.

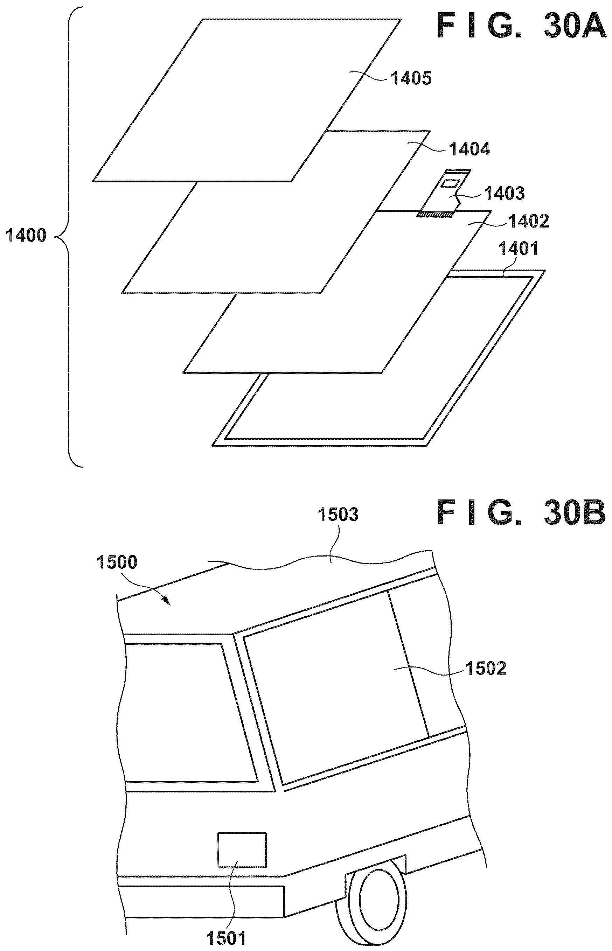

Fig. 30A is a schematic view showing an illumination device 1400 as an example of an illumination device according to this embodiment. The illumination device 1400 can include a housing 1401, a light source 1402, a circuit board 1403, an optical film 1404, and a light diffusing unit 1405. The light source 1402 includes the light emitting device 100 according to the embodiment. The optical film 1404 can be a filter (optical filter) that improves the color rendering of the light source 1402. When performing lighting-up or the like, the light diffusing unit 1405 can throw the light of the light source 1402 over a broad range by effectively diffusing the light. The optical film 1404 and the light diffusing unit 1405 may be provided on the light emission side of the illumination device 1400. A cover may be provided on the outermost portion, as needed.

The illumination device 1400 is, for example, a device for illuminating the interior of the room. The illumination device 1400 can emit white light, natural white light, or light of another color (any color from blue to red). White has a color temperature of 4,200 K, and natural white has a color temperature of 5,000 K. The illumination device 1400 can also include a light control circuit for controlling the light emission colors of the illumination device 1400. The illumination device 1400 can also include a power supply circuit connected to the light source 1402. The power supply circuit is a circuit for converting an AC voltage into a DC voltage. The illumination device 1400 may include a color filter. In addition, the illumination device 1400 can include a heat radiation unit. The heat radiation unit radiates the internal heat of the device to the outside of the device, and examples are a metal having a high specific heat and liquid silicon.

Fig. 30B is a schematic view showing an automobile 1500 that is an example of a moving body according to this embodiment. The automobile 1500 can include a taillight 1501 that is an example of a lighting appliance. The taillight 1501 is turned on when performing a braking operation or the like.

The taillight 1501 includes the light emitting device 100 according to the embodiment. The taillight 1501 can include a protection member for protecting the light emitting device 100. The material of the protection member is not limited as long as the material is a transparent material with a strength that is high to some extent, and the protection member is preferably made of polycarbonate or the like. A furandicarboxylic acid derivative, an acrylonitrile derivative, or the like may be mixed in polycarbonate.

The automobile 1500 can include a vehicle body 1503, and a window 1502 attached to the vehicle body 1503. The window 1502 can be a window for checking the front and back of the automobile 1500, and otherwise, can be a transparent display. The transparent display can include the light emitting device 100 according to the embodiment. In this case, the constituent materials of the electrodes and the like of the light emitting device 100 are formed by transparent members.

The moving body according to this embodiment may be a ship, an aircraft, a drone, or the like. The moving body may include a main body and a lighting appliance provided in the main body. The lighting appliance may emit light to show the position of the main body. The lighting appliance includes the light emitting device 100 according to the embodiment.

The display device according to this embodiment (a display device that includes the light emitting device 100 according to the embodiment, and performs display using light emitted from the light emitting device 100) can be applied to, for example, a wearable device such as smartglasses, an HMD, or a smart contact lens. The display device according to this embodiment can also be applied to a system including a wearable device or the like. An image capturing display device used as a wearable device or the like includes an image capturing device capable of photoelectrically converting visible light and a display device capable of emitting visible light.

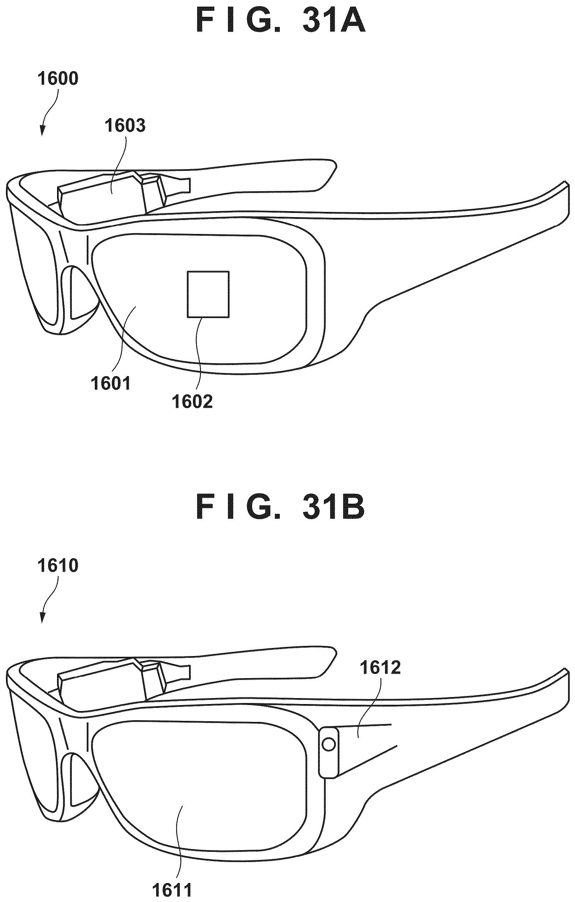

Fig. 31A is a schematic view showing glasses 1600 (smartglasses) as an example of the wearable device according to this embodiment. An image capturing device 1602 such as a CMOS sensor or a SPAD is provided on the front surface side of a lens 1601 of the glasses 1600. In addition, the display device according to this embodiment (a display device that includes the light emitting device 100 according to the embodiment, and performs display using light emitted from the light emitting device 100) is provided on the back surface side of the lens 1601.

The glasses 1600 further include a control device 1603. The control device 1603 functions as a power supply that supplies electric power to the image capturing device 1602 and the above-described display device. In addition, the control device 1603 controls the operations of the image capturing device 1602 and the display device. An optical system configured to condense light to the image capturing device 1602 is formed on the lens 1601.

Fig. 31B is a schematic view showing glasses 1610 (smartglasses) as an example of the wearable device according to this embodiment. The glasses 1610 include a control device 1612. An image capturing device corresponding to the image capturing device 1602 and the display device according to this embodiment are mounted on the control device 1612. The image capturing device in the control device 1612 and an optical system configured to project light emitted from the display device are formed in a lens 1611, and an image is projected onto the lens 1611. The control device 1612 functions as a power supply that supplies electric power to the image capturing device and the display device, and controls the operations of the image capturing device and the display device.

The control device may include a line-of-sight detection unit that detects the line of sight of a wearer of the glasses 1610. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of the quality of the image projected on the lens 1611 from the display device. The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used. More specifically, line-of-sight detection processing based on pupil corneal reflection method is performed. Using pupil corneal reflection method, a line-of-sight vector representing the direction (rotation angle) of the eyeball is calculated based on the image of the pupil and the Purkinje image included in the captured image of the eyeball, thereby detecting the line-of-sight of the user.

When performing display control based on visual detection (line-of-sight detection), the light emitting device 100 according to the embodiment can be applied to smartglasses including an image capturing device configured to capture the outside. The smartglasses can display captured outside information in real time.

The display device according to this embodiment (a display device that includes the light emitting device 100 according to the embodiment, and performs display using light emitted from the light emitting device 100) can include an image capturing device including a light receiving element, and control a displayed image based on the line-of-sight information of the user from the image capturing device. More specifically, the display device decides a first visual field region at which the user is gazing and a second visual field region other than the first visual field region based on the line-of-sight information. The first visual field region and the second visual field region may be decided by the control device of the display device, or those decided by an external control device may be received by the display device. In the display region of the display device, the display resolution of the first visual field region may be controlled to be higher than the display resolution of the second visual field region. That is, the resolution of the second visual field region may be lower than that of the second visual field region.

In addition, the display region can include a first display region and a second display region different from the first display region, and a region of higher priority can be decided from the first display region and the second display region based on line-of-sight information. The first display region and the second display region may be decided by the control device of the display device, or those decided by an external control device may be received by the display device. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the display device, the image capturing device, or an external device. If the external device holds the AI program, it is transmitted to the display device via communication.

As described above, when the light emitting device 100 according to the embodiment is used for various kinds of devices, it is possible to perform display with high quality and good light emission.

The present invention is not limited to the above embodiments and various changes and modifications can be made within the spirit and scope of the present invention. Therefore, to apprise the public of the scope of the present invention, the following claims are made.

This application claims priority from Japanese Patent Application Nos. 2023-013285 filed January 31, 2023, and 2023-189525 filed November 6, 2023, which are hereby incorporated by reference herein.

## Claims

1. A light emitting device that comprises a first light emitting element and a second light emitting element formed on a substrate, and a first microlens and a second microlens arranged so as to correspond to the first light emitting element and the second light emitting element, respectively,

   the first light emitting element including a first light emitting layer containing an organic compound, and an optical resonance structure having a first optical path length, and
   the second light emitting element including a second light emitting layer containing an organic compound, and an optical resonance structure having a second optical path length longer than the first optical path length, wherein assuming that an area of a region where light having entered from a normal direction of the substrate and having passed through the first microlens enters a light emission region of the first light emitting layer and a periphery thereof is defined as S1, an area of the light emission region of the first light emitting layer is defined as S1', an area of a region where light having entered from a normal direction of the substrate and having passed through the second microlens enters a light emission region of the second light emitting layer and a periphery thereof is defined as S2, and an area of the light emission region of the second light emitting layer is defined as S2', a relationship expressed by

$$|S_1 - S_1'| < |S_2 - S_2'|$$

   is satisfied, and
   in each of the first light emitting element and the second light emitting element, one region of the region where the light enters and the light emission region is included in the other region.

2. A light emitting device that comprises a first light emitting element and a second light emitting element formed on a substrate, and a first microlens and a second microlens arranged so as to correspond to the first light emitting element and the second light emitting element, respectively,

   the first light emitting element including a first light emitting layer and an optical resonance structure, and the second light emitting element including a second light emitting layer and an optical resonance structure having a higher interference order than the first light emitting element, wherein

assuming that an area of a region where light having entered from a normal direction of the substrate and having passed through the first microlens enters a light emission region of the first light emitting layer and a periphery thereof is defined as S1, an area of the light emission region of the first light emitting layer is defined as S1', an area of a region where light having entered from a normal direction of the substrate and having passed through the second microlens enters a light emission region of the second light emitting layer and a periphery thereof is defined as S2, and an area of the light emission region of the second light emitting layer is defined as S2', a relationship expressed by

$$|S1 - S1'| < |S2 - S2'|$$

is satisfied, and
in each of the first light emitting element and the second light emitting element, one region of the region where the light enters and the light emission region is included in the other region.

3. The light emitting device according to claim 1, **characterized in that**, assuming that an optical path length is defined as Lr, each of the first optical path length and the second optical path length satisfies

$$(2 \times m - (\phi r/\pi)) \times (\lambda/4) - \lambda/8 < Lr < (2 \times m - (\phi r/\pi)) \times (\lambda/4) + \lambda/8$$

where $\lambda$ is a peak wavelength of an emission spectrum of one of the first light emitting element and the second light emitting element, $\phi r$ is a phase shift generated when light of the wavelength $\lambda$ is reflected, and m is an integer of not less than 0.

4. The light emitting device according to any one of claims 1 to 3, **characterized in that** the $S_1$, the $S_1'$, the $S_2$, and the $S_2'$ satisfy a relationship expressed by $|S_1 - S_2| < |S_1' - S_2'|$.

5. The light emitting device according to any one of claims 1 to 3, **characterized in that** the $S_1$, the $S_1'$, the $S_2$, and the $S_2'$ satisfy a relationship expressed by $|S_1 - S_2| > |S_1' - S_2'|$.

6. The light emitting device according to any one of claims 1 to 5, **characterized in that** a height of the first microlens is larger than a height of the second microlens.

7. The light emitting device according to any one of claims 1 to 5, **characterized in that** a height of the second microlens is larger than a height of the first microlens.

8. The light emitting device according to any one of claims 1 to 6, **characterized in that** a radius of the first microlens is larger than a radius of the second microlens.

9. The light emitting device according to any one of claims 1 to 7, **characterized in that** a radius of the second microlens is larger than a radius of the first microlens.

10. The light emitting device according to any one of claims 1 to 9, **characterized in that** both the first light emitting element and the second light emitting element include the first light emitting layer and the second light emitting layer as a continuous common layer.

11. The light emitting device according to any one of claims 1 to 10, **characterized in that** a charge generation layer is provided between the first light emitting layer and the second light emitting layer.

12. A photoelectric conversion device **characterized by** comprising:

an optical unit having a plurality of lenses;
an image sensor configured to receive light having passed through the optical unit; and
a display unit configured to display an image captured by the image sensor,
wherein the display unit includes a light emitting device defined in any one of claims 1 to 11.

13. An electronic apparatus **characterized by** comprising:

    a display unit including a light emitting device defined in any one of claims 1 to 11;
    a housing provided with the display unit; and
    a communication unit provided in the housing and configured to perform external communication.

14. An illumination device **characterized by** comprising:

    a light source including a light emitting device defined in any one of claims 1 to 11; and
    one of a light diffusing unit and an optical film configured to transmit light emitted by the light source.

15. A moving body **characterized by** comprising:

    a lighting appliance including a light emitting device defined in any one of claims 1 to 11; and
    a body provided with the lighting appliance.

FIG. 1

# FIG. 2

# FIG. 3

LIGHT BEAM

# FIG. 4

**F I G. 5A**

INCIDENT LIGHT

INCIDENT REGION

30

INCIDENT REGION

**F I G. 5B**

θ INCIDENT LIGHT

INCIDENT REGION

30

INCIDENT REGION

30

## F I G. 6A

7

INCIDENT
LIGHT

1

30

INCIDENT REGION

INCIDENT REGION =
LIGHT EMISSION
REGION

## F I G. 6B

7

θ

INCIDENT
LIGHT

1

30

INCIDENT REGION

INCIDENT
REGION

30

**F I G. 7A**

INCIDENT REGION

30

INCIDENT REGION

**F I G. 7B**

INCIDENT LIGHT

INCIDENT REGION

30

INCIDENT REGION

# F I G. 8

LIGHT EMISSION POSITION

REFLECTING PORTION

# F I G. 9

MICROLENS B

MICROLENS C

MICROLENS A

INCIDENT
LIGHT

INCIDENT LIGHT A

INCIDENT LIGHT B

INCIDENT LIGHT C

1

INCIDENT
REGION A

INCIDENT REGION C

INCIDENT REGION B

INCIDENT REGION A

LIGHT EMISSION
REGION

INCIDENT REGION B

INCIDENT REGION C

# F I G. 10

VIEW ANGLE (LUMINANCE)

OBSERVATION ANGLE [θ]

# F I G. 11

# FIG. 12

EP 4 648 585 A1

# FIG. 13

EP 4 648 585 A1

F I G. 14

# FIG. 15

OPENING A
(LIGHT EMITTING PORTION)

OPENING B
(LIGHT EMITTING PORTION)

# F I G. 16

EP 4 648 585 A1

# F I G. 17

EP 4 648 585 A1

# FIG. 18

EP 4 648 585 A1

# FIG. 19

EP 4 648 585 A1

F I G. 20

FIG. 21

31-2

31-1

OPENING B
(LIGHT EMITTING PORTION)

OPENING A
(LIGHT EMITTING PORTION)

6  4  3  5  1

7

2

# FIG. 22

8-1    8-2

9

6

4

31-1    31-2

3

5

1

2

OPENING A
(LIGHT EMITTING PORTION)

OPENING B
(LIGHT EMITTING PORTION)

EP 4 648 585 A1

# FIG. 23

# F I G. 24

# FIG. 25

OPENING A
(LIGHT EMITTING PORTION)

OPENING B
(LIGHT EMITTING PORTION)

EP 4 648 585 A1

# FIG. 26

EP 4 648 585 A1

FIG. 27

# F I G. 28A

# F I G. 28B

# F I G. 29A

1300

1301 1302

1303

# F I G. 29B

1310

1314

1311

1312

1313

# F I G. 30A

1405
1404
1403
1402
1401
1400

# F I G. 30B

1503
1500
1502
1501

# FIG. 31A

1600

1603

1601

1602

# FIG. 31B

1610

1612

1611

## INTERNATIONAL SEARCH REPORT

| International application No. |
|---|
| **PCT/JP2024/000941** |

| A. | CLASSIFICATION OF SUBJECT MATTER |
|---|---|

*H10K 50/852*(2023.01)i; *H10K 50/19*(2023.01)i; *H10K 50/854*(2023.01)i; *H10K 50/858*(2023.01)i; *H10K 59/10*(2023.01)i; *H10K 59/35*(2023.01)i; *H10K 59/38*(2023.01)i; *H10K 59/60*(2023.01)i

According to International Patent Classification (IPC) or to both national classification and IPC

| B. | FIELDS SEARCHED |
|---|---|

Minimum documentation searched (classification system followed by classification symbols)

H10K50/852; H10K50/19; H10K50/854; H10K50/858; H10K59/10; H10K59/35; H10K59/38; H10K59/60

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2022/220111 A1 (CANON KABUSHIKI KAISHA) 20 October 2022 (2022-10-20)<br>fig. 2, 8 | 1-15 |
| A | WO 2022/220103 A1 (CANON KABUSHIKI KAISHA) 20 October 2022 (2022-10-20)<br>fig. 1, 4 | 1-15 |
| A | WO 2015/029203 A1 (HITACHI, LTD.) 05 March 2015 (2015-03-05)<br>fig. 5 | 1-15 |
| A | WO 2021/261262 A1 (SONY SEMICONDUCTOR SOLUTIONS CORPORATION) 30 December 2021 (2021-12-30)<br>fig. 5 | 1-15 |
| A | US 2014/0374705 A1 (SAMSUNG DISPLAY CO., LTD.) 25 December 2014 (2014-12-25)<br>fig. 11 | 1-15 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 March 2024** | **02 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**EP 4 648 585 A1**

| INTERNATIONAL SEARCH REPORT<br>Information on patent family members | | International application No.<br>**PCT/JP2024/000941** |
|---|---|---|

| Patent document<br>cited in search report | | | Publication date<br>(day/month/year) | Patent family member(s) | | | Publication date<br>(day/month/year) |
|---|---|---|---|---|---|---|---|
| WO | 2022/220111 | A1 | 20 October 2022 | JP | 2022-162966 | A | |
| | | | | KR | 10-2023-0166115 | A | |
| WO | 2022/220103 | A1 | 20 October 2022 | JP | 2022-162965 | A | |
| | | | | CN | 117121637 | A | |
| WO | 2015/029203 | A1 | 05 March 2015 | TW | 201517346 | A | |
| WO | 2021/261262 | A1 | 30 December 2021 | US | 2023/0269993 | A1 | |
| | | | | fig. 5 | | | |
| | | | | KR | 10-2023-0027006 | A | |
| | | | | TW | 202205913 | A | |
| US | 2014/0374705 | A1 | 25 December 2014 | KR | 10-2014-0148099 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022080507 A
- JP 2023013285 A
- JP 2023189525 A